# EUROPÄISCHE PATENTSCHRIFT

(11) **EP 4 252 274 B1**
(45) Veröffentlichungstag und Bekanntmachung des Hinweises auf die Patenterteilung: **14.10.2026**
(21) Anmeldenummer: 21798381.6
(22) Anmeldetag: 22.10.2021
(51) Int. Cl.: H10W 72/00, H10W 90/00, H10W 72/30

(54) **THERMOKOMPRESSIONSVORRICHTUNG UND VERFAHREN ZUM VERBINDEN VON ELEKTRISCHEN BAUTEILEN MIT EINEM SUBSTRAT**
THERMOCOMPRESSION APPARATUS AND METHOD FOR CONNECTING ELECTRICAL COMPONENTS TO A SUBSTRATE
DISPOSITIF DE THERMOCOMPRESSION ET PROCÉDÉ POUR RELIER DES COMPOSANTS ÉLECTRIQUES À UN SUBSTRAT

(30) Priorität: 26.11.2020 DE 102020007235
(43) Veröffentlichungstag der Anmeldung: 04.10.2023
(73) Patentinhaber: MB Automation GmbH & Co. KG, 93426 Roding (DE)
(72) Erfinder: HOLZNER, Benjamin, 92526 Oberviechtach (DE); AUGST, Uwe Franz, 92442 Wackersdorf (DE)
(74) Vertreter: Schmidt, Steffen J.
(86) Internationale Anmeldenummer: PCT/EP2021/079313
(87) Internationale Veröffentlichungsnummer: WO 2022/111917

(56) Entgegenhaltungen:
- US-A1- 2009 289 098
- US-A1- 2016 029 494

## Beschreibung

### Hintergrund

Hier wird eine Thermokompressionsvorrichtung und ein Verfahren zum Verbinden elektrischer Bauteile mit einem Substrat beschrieben. Insbesondere wird hier beschrieben, wie ein elektrisches Bauteil für die Dauer eines Aushärtevorgangs eines Klebstoffs gegen das Substrat gepresst wird. Bei der Herstellung von Chipkarten oder RFID (Radio-Frequency-IDentification)-Etiketten werden Thermokompressionsverfahren verwendet, um elektrische Bauteile mechanisch (und elektrisch leitend) mit einem Substrat zu verbinden. Derartige Verfahren werden insbesondere verwendet, um Halbleiterchips im Flip-Chip-Design mit einem Substrat zu verbinden.

### Stand der Technik

Die Thermokompression beschreibt ein Verbindungsverfahren, bei dem Komponenten durch einen vorübergehenden Kraft- und Wärmeeintrag miteinander verbunden werden. Aus dem Stand der Technik sind Thermokompressionsvorrichtungen zum Verbinden von elektrischen Bauteilen mit einem Substrat bekannt.

Ein zwischen dem elektronischen Bauteil und dem Substrat befindliches Klebstoffdepot wird mit einem definierten Temperatur-Zeitprofil gehärtet. Während des Temperatur-Zeitprofils wird das elektronische Bauteil an das Substrat gepresst. Solche Thermodenanordnungen arbeiten zum industriellen Verbinden der Bauteile meist in einem Betriebstemperaturbereich < 250°C und Prozesszeiten > 1 Sekunde bis zu < 10 Sekunden. Diese beiden Prozessparameter werden durch einen (Temperatur-) Sensor bzw. durch die mechanische Verfahrbewegung über der Zeit kontrolliert. In einigen Anordnungen wird dieser der Anpressdruck oder die Anpresskraft während einer Einstellphase der Anordnung In einer Justierung vor einem Produktionsbetrieb der Anordnung messtechnisch geprüft und eingestellt. Dazu wird temporär ein Kraftmesssensor in den Arbeitsweg einer Thermodenanordnung eingebracht.

Derartige Vorrichtungen sind beispielsweise durch Tag Module Assembly (TMA) Lines offenbart, in welchen ein Substrat mit darauf angeordneten elektrischen Bauteilen kontinuierlich zwischen zwei andrückenden Heizschienen bewegt wird. Dabei können Relativbewegung zwischen den zu verbindenden Komponenten und den Heizschienen auftreten, die jedoch Auswirkungen auf die Positionierungsgenauigkeit haben können. Deshalb wird ein derartiger Aufbau zur Herstellung von Erzeugnissen mit größeren Positionstoleranzen verwendet.

Die US-A-2016029494 offenbart eine Montagevorrichtung für elektronische Bauteile mit einem Bondwerkzeug zum thermischen Bonden eines elektronischen Bauteils auf ein Substrat, wobei das Bondwerkzeug in einer Richtung angetrieben wird, in der es sich dem Substrat nähert und sich von diesem entfernt, einer linearen Skala und einem linearen Skalenkopf, die die Position des Bondwerkzeugs in der Richtung erfassen, in der es sich dem Substrat nähert und sich von diesem entfernt, und eine Steuereinheit, die so konfiguriert ist, dass sie die Position des Bonding-Werkzeugs in der Richtung, in der es sich dem Substrat nähert und entfernt, hält, wenn ein Lötfilm zwischen einer Elektrode des elektronischen Bauteils und einer Elektrode des Substrats thermisch geschmolzen wird, wenn sich das Bonding-Werkzeug dem Substrat um einen vorbestimmten Abstand von einer Referenzposition nähert, während das elektronische Bauteil erhitzt wird.

Aus der DE 10 2012 012 879 B3 ist eine Thermokompressionsvorrichtung zum Verbinden elektrischer Bauteile mit einem Substrat bekannt. Die Vorrichtung weist Walzen auf, über die das Substrat geführt wird. Eine Antriebswalze dient dabei zur schrittweisen Förderung des Substrats. Weiterhin weist die Vorrichtung eine Auflage für das Substrat auf, eine als Druckband dienende Stahlfolie, sowie Magnete, durch die das Druckband angezogen wird, so dass es die elektrischen Bauteile auf das Substrat drückt. An der Auflage ist eine Heizschiene angebracht. Weiterhin weist die Vorrichtung eine Hubeinheit auf, an der das Druckband befestigt ist und die dazu eingerichtet ist, relativ zur Auflage angehoben und abgesenkt zu werden. An der Hubeinheit ist ein Heizstrahler angebracht. Im Betrieb wird das Substrat mit einem flüssigen Verbindungsmittel und den elektrischen Bauteilen zwischen die Auflage und das Druckband gefördert. Dann wird die Hubeinheit abgesenkt, so dass das Druckband durch die Wirkung der Magnete die elektrischen Bauteile gegen das Substrat presst. Um das Verbindungsmittel auszuhärten, wird durch die Heizschiene und den Heizstrahler Wärme zugeführt. Die Vorrichtung kann kostengünstig hergestellt werden und die elektrischen Bauteile lassen sich mit definierter Kraft auf das Substrat drücken.

Allerdings haben im Betrieb weder die Heizschiene, noch der Heizstrahler direkten Kontakt zu dem Substrat und den elektrischen Bauteilen. Insbesondere gibt der an der Hubeinheit angebrachte Heizstrahler Wärme in Form von Wärmestrahlung ab, die dann erst nach Erreichen des Druckbandes Letzteres erwärmt. Durch die Heizstrahlen dauert es somit einige Zeit, bis sich das Druckband auf eine bestimmte zur Aushärtung des Verbindungsmittels geeignete Temperatur erwärmt hat. Hierdurch ist der mit der Vorrichtung erzielbare Durchsatz begrenzt.

Aus der EP 1 780 782 A1 ist eine Vorrichtung zur Chip-Herstellung bekannt, bei der in einem kontinuierlichen Verfahren ein Chip und ein Substrat mittels Druck und Wärmezufuhr verbunden werden. Der Druck wird dabei durch magnetische Kräfte bewirkt. Die Wärmezufuhr erfolgt mit heißer Druckluft, die über Düsen auf das Substrat gerichtet abgegeben wird. Zum Einbringen eines Kraft- und Wärmeeintrags auf die zu verbindenden Komponenten ist weiterhin die Verwendung von Heizstempel-Einheiten bekannt. Beispielsweise offenbaren die EP 2 506 295 A2 und die JP H-03225842 (A) Vorrichtungen, bei denen ein Substrat und mehrere darauf angeordnete Halbleiterchips auf einer Halteplatte aufliegen und mittels einer Heizstempel-Einheit verbunden werden. Durch die Heizstempel-Einheit wird eine Kraft auf die zu verbindenden Komponenten ausgeübt, sodass diese gegen die Halteplatte gepresst werden.

Weiter erfolgt durch eine Wärmequelle in dem Heizstempel eine Wärmezufuhr, um einen zwischen dem Substrat und den Halbleiterchips aufgetragenen Klebstoff auszuhärten.

Zur Herstellung von elektronischen Baugruppen mit einer Duroplastschicht offenbaren die US 2009/0291524 A1 und die WO 2010/095311 A1 weiterhin Thermokompressionsvorrichtungen mit Heizstempel-Einheiten. Die herzustellenden Baugruppen bestehen aus einem Substrat mit darauf angeordneten Halbleiterchips, über welche sich die Duroplastschicht erstreckt. Die Heizstempel-Einheit bewirkt, dass die Komponenten der elektronischen Baugruppe einer Kraft- und Wärmeeinwirkung ausgesetzt sind, sodass das Substrat und die Halbleiterchips durch die darauf angeordnete Duroplastschicht miteinander verbunden werden.

Die Bereitstellung von Heizstempel-Einheiten hat jedoch Auswirkungen auf den konstruktiven Aufwand und die Kosten derartiger Thermokompressionsvorrichtungen.

Die WO 00/41219 A1 offenbart eine Vorrichtung zum Verbinden von auf einem Substrat angeordneten Bauteilen mit dem Substrat, wobei die Vorrichtung eine Aufsetzstation zum Platzieren einer Mehrzahl elektronischer Bauteile auf dem Substrat und eine davon separierte Nachpressstation zum Verbinden der Bauteile mit dem Substrat aufweist. Die Nachpressstation umfasst ein Oberwerkzeug mit einer Mehrzahl von in Richtung einer Auflagefläche für das Substrat verschiebbar gelagerten Stößeln, die als Thermodenanordnungen bereitgestellt sind. Die Stößel sind dazu eingerichtet, eine Anpresskraft auf jeweils ein Bauteil auszuüben. Um unterschiedliche Höhen der zu behandelnden Bauteile auf dem Substrat auszugleichen, umfasst die Vorrichtung ferner eine Flüssigkeitskammer zur hydrostatischen Verteilung einer Beaufschlagungskraft auf die einzelnen Stößel. Die Flüssigkeitskammer erstreckt sich entlang der Stößelrückseiten und ist mittels einer flexiblen Membran gegenüber den Stößeln abgedichtet. Aus Sicherheitsgründen, werden die Stößel unter der Vorspannung von Federn gegen die Membran gepresst, sodass die Stößel in Richtung einer Ausgangslage vorgespannt sind.

Die US 6 015 081 A offenbart eine Thermokompressionsvorrichtung zum elektrisch leitenden Verbinden von aufeinander angeordneten elektronischen Bauteilen. Um eine gleichmäßige Anpresskraft zwischen den Bauteilen zu gewährleisten, umfasst die Vorrichtung eine Blattfeder, die mittels eines Anpressmittels eine Anpresskraft auf die auf einer Auflagefläche angeordneten Bauteile ausübt. Die Blattfeder ist dabei an ihren jeweiligen Endabschnitten mit dem Anpressmittel im Kontakt.

Die WO 2016/192926 A1 betrifft eine Thermokompressionsvorrichtung zum Verbinden elektrischer Bauteile mit einem Substrat, umfassend ein Oberwerkzeug und ein Unterwerkzeug mit einer ersten Wärmequelle und einer Auflagefläche zum Auflegen des Substrats mit zumindest einem darauf angeordneten elektrischen Bauteil. Das Oberwerkzeug umfasst ein Anpresselement mit zumindest einem Federelement. Das Federelement ist dazu eingerichtet, bei einer Relativbewegung zwischen dem Oberwerkzeug und dem Unterwerkzeug elastisch verformt zu werden und dadurch eine Kraft auf ein sich zwischen dem Anpresselement und der Auflagefläche befindliches Substrat mit zumindest einem darauf angeordneten elektrischen Bauteil auszuüben, um das elektrische Bauteil für die Dauer eines Aushärtevorgangs gegen das auf der Auflagefläche anzuordnende Substrat zu pressen. Weiterhin ist die erste Wärmequelle dazu eingerichtet, dem zwischen der Auflagenfläche und dem Anpresselement anzuordnenden Substrat mit dem elektrischen Bauteil Wärme zuzuführen, um ein zwischen dem Substrat und dem zumindest einen elektrischen Bauteil aufgebrachtes Verbindungsmittel auszuhärten.

### Zugrundeliegendes Problem

Hieraus ergibt sich die Aufgabe, eine Vorrichtung und ein Verfahren bereitzustellen, die ein aufwands- und kostenreduziertes Verbinden von elektrischen Bauteilen mit einem Substrat bei hohem Durchsatz (Stückzahl pro Zeiteinheit) sicherstellen. Die bereitzustellende Vorrichtung und das Verfahren sollen mittels einer Hochtemperatur -Thermodenanordnung das Verbinden eines elektronischen Bauteils (z.B. Chip) und einem Substrat (z.B. Leiterplatte oder RFID-Antennenmaterial oder dergl.) ermöglichen.

### Vorgeschlagene Lösung

Zur Lösung dieser Aufgabe werden gemäß den unabhängigen Ansprüchen eine Thermokompressionsvorrichtung, sowie ein Verfahren zum Verbinden elektrischer Bauteilen mit einem Substrat vorgeschlagen.

Ein erster Aspekt betrifft eine Thermokompressionsvorrichtung zum Verbinden elektrischer Bauteile gemäß dem Anspruch 1.

### Ausgestaltung und Eigenschaften

Die elektrischen Bauteile können dabei in Form von Halbleiterchips, RFID-Chips, Hi-Q-LED's, etc. bereitgestellt sein. Ferner können die elektrischen Bauteile flach ausgebildet sein und an einer Seite, welche auf dem Substrat anzuordnen ist, elektrische Kontakte aufweisen. Die elektrischen Kontakte können beispielsweise als Kontaktstellen, insbesondere in Form von "Bumps" bereitgestellt und dazu eingerichtet sein, mit auf dem Substrat angeordneten Kontakten oder Leiterflecken elektrisch leitfähig verbunden zu werden. Die auf dem Substrat befindlichen Kontakte können als Metallschicht ausgebildet sein.

Weiterhin kann das Substrat eines oder mehrere Materialien der Gruppe Papier, Polyvinylchlorid (PVC), Polyethylen (PE), Polyethylenterephthalat (PET) oder Glykol-modifiziertes Polyethylenterephthalat (PETG), Polyethylennaphthalat (PEN), Acrylnitril-Butadien-Styrol-Copolymerisat (ABS), Polyvinylbutyral (PVB), Polymethylmethacrylat (PMMA), Polyimid (PI), Polyvinylalkohol (PVA), Polystyrol (PS), Polyvinylphenol (PVP), Polypropylen (PP), Polycarbonat (PC) oder deren Derivate enthalten.

Zum Verbinden der elektrischen Bauteile mit dem Substrat ist weiterhin vorgesehen, dass zwischen den elektrischen Bauteilen und dem Substrat ein Verbindungsmittel aufgetragen ist. Das Verbindungsmittel ist bevorzugt als thermisch aushärtbarer Klebstoff, insbesondere als flüssiger Klebstoff bereitgestellt. Ferner kann der Klebstoff elektrisch leitend und dazu eingerichtet sein, die elektrischen Bauteile und das Substrat mechanisch und elektrisch leitend miteinander zu verbinden.

Insbesondere kann als Klebstoff ein anisotrop leitfähiger, warmhärtender Klebstoff auf der Basis eines modifizierten Epoxidharzes verwendet werden, der einkomponentig, warmhärtend, lösungsmittelfrei und/oder gefüllt ist. Der Klebstoff ist z.B. bei einer Temperatur von etwa +100 °C bis etwa +250 °C mittels der Thermodenvorrichtung auszuhärten, wobei höhere Temperaturen die Aushärtung verkürzen, und niedrigere Temperaturen die Aushärtung verlängern. Eine Variante des Klebstoffs ist DELO MONOPOX AC6545. Eine rasche Aushärtung ist für hohe Fertigungsgeschwindigkeiten essentiell. Beim Einsatz einer 230 °C heißen Thermode erlaubt DELO MONOPOX AC6545 ein Aushärten innerhalb von einer Sekunde. Mit den oben angegebenen höheren Temperaturbereichen sind noch kürzere Aushärtungszeiten erreichbar.

In einer weiteren Variante kann über dem Substrat mit den darauf angeordneten elektrischen Bauteilen eine Trennschicht angeordnet sein. Dadurch kann verhindert werden, dass das Oberwerkzeug während des Aushärtevorgangs mit dem Verbindungsmittel in Kontakt tritt.

In der hier vorgeschlagenen Vorrichtung sind das Oberwerkzeug und das Unterwerkzeug aufeinander zu- und voneinander weg bewegbar. In einer Variante der Vorrichtung können das Oberwerkzeug und das Unterwerkzeug zusätzlich zu den Bewegungen der ersten und zweiten Antriebe in einer Längsrichtung der Vorrichtung (in Förderrichtung des Substrats) gemeinsam bewegbar sein. Dadurch kann das Anordnen und Entfernen der zu verarbeitenden Komponenten auf und von der Auflagefläche vereinfacht werden. Außerdem kann so der Zeitraum länger sein, während dem das Oberwerkzeug und das Unterwerkzeug geschlossen sind und die Thermode den Klebstoff aushärtet.

Ferner kann die Vorrichtung eine weitere Antriebseinheit aufweisen, um das Oberwerkzeug und/oder das Unterwerkzeug in einer horizontalen Richtung relativ zueinander zu bewegen.

In einer weiteren Variante der Vorrichtung sind das Oberwerkzeug und das Unterwerkzeug (oder zumindest deren jeweils mit dem Substrat bzw. dem Bauteil in Kontakt kommende Komponenten) in Förderrichtung des Substrats mit diesem durch entsprechende Antriebe bewegbar ausgestaltet. So kann das Substrat als quasi endloses Band ausgestaltet sein, auf dem in der vorgeschlagenen Vorrichtung vorangehenden Arbeitsstationen /-schritten portionierter Klebstoff und Bauteile aufgebracht werden.

In einer Variante ist die Wärmequelle am Oberwerkzeug. In einer weiteren Variante ist ist auch das Unterwerkzeug mit einer Wärmequelle ausgestattet, um den Klebstoff vorzuheizen.

Die Klebstoffhärtung findet mit der Wärmequelle des Oberwerkzeugs statt.

In einer Variante der Vorrichtungkann das Oberwerkzeug eine zweite Wärmequelle umfassen, die dazu eingerichtet ist, dem zwischen der Auflagenfläche und dem Anpresselement anzuordnenden Substrat mit dem zumindest einen elektrischen Bauteil weiterhin Wärme zuzuführen, um das zwischen dem Substrat und dem zumindest einen elektrischen Bauteil aufgebrachte Verbindungsmittel auszuhärten.

Die Thermode ist als Wärmequelle dazu eingerichtet, eine Wärmezufuhr zu dem Bauteil / dem Klebstoff / dem Substrat mittels Wärmeleitung, d.h. berührend einzubringen. Hierzu kann die Thermode in Form eines Heizwiderstands, z.B. als Heizdraht, etc., ausgebildet sein. Der Heizdraht erwärmt eine Anpressfläche des Anpresselements, welches die Wärme dann auf das Substrat / den Chip überträgt.

Der erste Antrieb ist in einer Variante der Vorrichtung dazu eingerichtet, das Unterwerkzeug oder das Oberwerkzeug in der ersten Bewegung zwischen einer ersten Position und einer zweiten Position zu bewegen. Der zweite Antrieb ist in einer Variante der Vorrichtung dazu eingerichtet ist, das Unterwerkzeug oder das Oberwerkzeug in der zweiten Bewegung zwischen der zweiten Position und einer dritten Position zu bewegen. Dabei ist in einer Variante der Vorrichtung vorzugsweise die erste Position eine Park-Position, die zweite Position eine Offen-Position, und die dritte Position eine Geschlossen-Position. Der erste Antrieb und der zweite Antrieb sind in einer Variante der Vorrichtung dazu eingerichtet und anzusteuern, die erste Bewegung und die zweite Bewegung entweder nacheinander oder zeitlich einander überlappend auszuführen.

Die Aufteilung des Gesamthubwegs zwischen dem Unterwerkzeug oder dem Oberwerkzeug aus der Park-Position über die zweite Position in die Geschlossen-Position auf die ersten und zweiten Antriebe mit unterschiedlichen Teilhubwegen und unterschiedlicher Geschwindigkeit erlaubt eine besonders hohe Gesamtdynamik und einen daraus resultierenden hohen Durchsatz.

Der erste Antrieb und der zweite Antrieb sind in einer Variante der Vorrichtung dazu eingerichtet, gleichsinnig oder gegensinnig wirken, um die Auf- / Zu-Bewegung des Unterwerkzeugs und des Oberwerkzeugs relativ zueinander zu bewirken. Dabei können in einer Variante der Vorrichtung die beiden Antriebe auf derselben Seite des Substrats, also nur entweder dem Ober- oder dem Unterwerkzeug zugeordnet sein. Alternativ dazu können in einer Variante der Vorrichtung die beiden Antriebe auf unterschiedlichen Seiten des Substrats, also dem Ober- und dem Unterwerkzeug zugeordnet sein.

Der erste Antrieb und der zweite Antrieb sind also entweder beide dem Unterwerkzeug oder dem Oberwerkzeug zugeordnet, oder einer der beiden Antriebe ist dem Unterwerkzeug und der andere der beiden Antriebe dem Oberwerkzeug zugeordnet.

Die Thermodenanordnung ist in einer Variante der Vorrichtung dazu eingerichtet und anzusteuern, in das Bauteil und/ oder das Substrat Heizenergie in einem Temperaturbereich von etwa 300°C bis etwa 500°C während eines Heizintervalls von etwa 0,07 bis etwa 1,5 Sekunden, oder etwa 0,1 bis kleiner als etwa 1 Sekunde einzuspeisen, um den zwischen das Bauteil und das Substrat eingebrachten Klebstoff thermisch auszuhärten. Dabei hat in einer Variante der Vorrichtung die Thermodenanordnung eine Anpressfläche für die Heizenergie von etwa kreisrunder Gestalt und einem Durchmesser von weniger als etwa 5 mm. Die Thermodenanordnung umfasst in einer Variante der Vorrichtung einen thermischen Isolierkörper, der ein zu bestromendes Heizelement nahezu vollständig umgibt. Dabei liegt in einer Variante der Vorrichtung zumindest die Anpressfläche frei.

Bei der Thermokompressionsvorrichtung ist in einer Variante der Vorrichtung dem Unterwerkzeug und/oder dem Oberwerkzeug ein Kraftsensor zugeordnet, der dazu eingerichtet ist, eine Anpresskraft zwischen dem Unterwerkzeug und dem Oberwerkzeug auf das zwischen diesen befindliche Substrat, das auf dem Substrat angeordnete Bauteil, und den zwischen das Bauteil und das Substrat eingebrachten Klebstoff zumindest in ausgewählten aufeinanderfolgender Geschlossen-Positionen des Unterwerkzeugs und des Oberwerkzeugs zu erfassen und an eine Steuerung zu signalisieren.

Bei der Thermokompressionsvorrichtung ist in einer Variante der Vorrichtung der erste Antrieb als pneumatischer oder hydraulischer Zylinder ausgestaltet, und der zweite Antrieb ist als Tauchspulenaktuator ausgestaltet.

Bei der Thermokompressionsvorrichtungsind in einer Variante der Vorrichtung der erste Antrieb und/oder der zweite Antrieb während der ersten Bewegung bzw. der zweiten Bewegung von der Steuerung im Regelschleifenbetrieb angesteuert. Dabei wird in einer Variante der Vorrichtung eine Kraftmessung mit dem oben genannten Kraftsensor und/oder eine Wegmessung zur Bestimmung einer Soll-Größe, insbesondere einer Kraft oder einer Weg-Position des ersten Antriebs und / oder des zweiten Antriebs verwendet.

In einer Variante ist der pneumatische oder hydraulische Zylinder mit einer Kolbenstange ausgestattet, über die eine Armatur mit dem zweiten Antrieb, der Thermodenanordnung und ggf. dem Kraftsensor zu bewegen ist. Diese Zylinder sind entweder einfach- oder doppeltwirkend ausgestaltet. Ein Zylinder kann mit einfacher oder durchgehender Kolbenstange, einer einstellbaren Endlagendämpfung und einem Sensor zur berührungslosen Positionserkennung ausgestaltet sein.

Bei dem Tauchspulenaktuator ist die Kraft eines stromdurchflossenen Leiters in einem (Permanent-)Magnetfeld proportional zur Magnetfeldstärke und zum durch den Leiter fließenden Strom. Bei einem Wechsel der Stromrichtung ändert sich auch die Kraftrichtung. So arbeitet der Tauchspulenaktuator bidirektional mit gleichem Verhalten in beide Arbeitsrichtungen. Die kleine bewegte Masse der Tauchspule erlaubt einen hochdynamischen Betrieb mit hoher Beschleunigung und kleiner Hysterese. So ist die zweite Bewegung des Unterwerkzeugs relativ zum Oberwerkzeug in beiden Richtungen gut kontrollierbar und reproduzierbar, auch bei Richtungsumkehr. Der Tauchspulenaktuator ist in seiner Bewegung sehr gut regelbar und zeigt ein geringes Überschießen; auch die durch ihn auf das Bauteil auszuübende Kraft ist sehr feinfühlig regelbar.

Der Tauchspulenaktuator erzeugt im Betrieb eine Gegenspannung (Back-EMF), die proportional zur Relativ-Geschwindigkeit zwischen Spule und Permanentmagnet ist, so dass der Aktuator bei konstanter Last und Speisung mit konstanter Spannung im stationären Zustand eine konstante Geschwindigkeit erreichen würde. Der Spulenwiderstand ist temperaturabhängig. Daher sind konstante Kraftverhältnisse mit einem zum Beispiel in der Steuerung implementierten Servoregler im Stromregelungsmodus erzielbar. Der Tauchspulenaktuator kann in unterschiedlichen Varianten der Vorrichtung sowohl mittels einer Stromregelung als auch mittels einer Geschwindigkeitsregelung betrieben.

Der Tauchspulenaktuator wirkt linear und die bewegte Tauchspule ist bei einer Variante der Vorrichtung in einem Rollenlager, alternativ in einem Gleitlager, geführt. In einer weiteren Ausgestaltung des Tauchspulenaktuators ist ein Positionssensor integriert. Der Tauchspulenaktuator kann auch ohne Eigenlagerung der bewegten Tauchspule ausgeführt sein. Die bewegte Tauchspule erzeugt eine gleichmäßige Kraft in beide Bewegungsrichtungen, wenn sie - wie in einer Variante des Tauchspulenaktuators - bipolar angesteuert wird. In dieser Variante hat der Tauchspulenaktuator eine besonders geringe Hysterese, was in der vorliegenden Anwendung sehr vorteilhaft ist, um eine Beeinträchtigung der Oberfläche des Bauteils beim Bewegen des Unterwerkzeugs relativ zum Oberwerkzeug zu vermeiden.

Ein weiterer Aspekt betrifft ein Verfahren zum Betreiben einer Thermokompressionsvorrichtung zum Verbinden elektrischer Bauteile mit einem Substrat gemäß dem Anspruch 4.

In einer Variante des Verfahrens werden der erste Antrieb, das Unterwerkzeug oder das Oberwerkzeug in der ersten Bewegung zwischen einer ersten Position und einer zweiten Position relativ zueinander bewegt. In einer Variante des Verfahrens werden der zweite Antrieb, das Unterwerkzeug oder das Oberwerkzeug in der zweiten Bewegung zwischen der zweiten Position und einer dritten Position relativ zueinander bewegt. Dabei sind vorzugsweise die erste Position eine Park-Position, die zweite Position eine Offen-Position, und die dritte Position eine Geschlossen-Position. Der erste Antrieb und der zweite Antrieb führen. In einer Variante des Verfahrens die erste Bewegung und die zweite Bewegung entweder nacheinander oder zeitlich einander überlappend aus. In einer Variante des Verfahrens werden das Substrat mit dem Bauteil und dem Klebstoff kontinuierlich und/oder intermittierend (getaktet) zwischen der Auflagefläche und dem Anpresselement des Unterwerkzeugs bzw. des Oberwerkzeugs in der Offen-Position des Unterwerkzeugs und des Oberwerkzeugs hindurch gefördert.

In einer Variante des Verfahrens beginnt in einer 1. Phase, nachdem der erste Antrieb die erste Bewegung soweit ausgeführt hat, dass sich das Unterwerkzeug und das Oberwerkzeug aus der Park-Position in die Offen-Position bewegt haben, der zweite Antrieb die zweite Bewegung auszuführen, damit sich das Unterwerkzeug und das Oberwerkzeug relativ zueinander aus der Offen-Position in die Geschlossen-Position bewegen.

In einer Variante des Verfahrens beschleunigt in einem Beschleunigungsabschnitt der 1. Phase der zweite Antrieb zum Ausführen der zweiten Bewegung solange, bis eine vorbestimmte erste Soll-Geschwindigkeit, z.B. 100 mm/s bis 300 mm/s, z.B. 200 mm/s erreicht ist, mit der sich das Unterwerkzeug und das Oberwerkzeug relativ zueinander aus der Offen-Position in die Geschlossen-Position bewegen.

In einer Variante des Verfahrens verzögert in einem Verzögerungsabschnitt der 1. Phase der zweite Antrieb zum Ausführen der zweiten Bewegung solange, bis eine vorbestimmte zweite, geringere als die erste Soll-Geschwindigkeit, z.B. 2 mm/s bis 20 mm/s, z.B. 5 mm/s erreicht ist, mit der sich das Unterwerkzeug und das Oberwerkzeug relativ zueinander aus der Offen-Position in die Geschlossen-Position bewegen, um mit dieser zweiten Soll-Geschwindigkeit das Bauteil und / oder eine Position des Bauteils auf dem Substrat zu erkennen.

In einer Variante des Verfahrens wird in einer 2. Phase, während sich das Unterwerkzeug und das Oberwerkzeug relativ zueinander aus der Offen-Position in die Geschlossen-Position bewegen, um durch Berühren des Bauteils das Bauteil und/oder dessen Position auf dem Substrat zu ermitteln, ein Ansteuersignal des zweiten Antriebs, z.B. eine Ansteuerspannung des Tauchspulenaktuators, auf einen vorbestimmten Maximalwert begrenzt. Dadurch wird erreicht, dass einem Auftreffen des Anpresselements des Oberwerkzeugs auf dem Bauteil dieses nicht zu beschädigt wird.

In einer Variante des Verfahrens wird in der 2. Phase, während sich das Unterwerkzeug und das Oberwerkzeug relativ zueinander aus der Offen-Position in die Geschlossen-Position bewegen, um das Bauteil und/oder dessen Position auf dem Substrat zu erkennen, fortlaufend oder intermittierend eine Momentangeschwindigkeit $\frac{Δ s}{Δ t}$ des Unterwerkzeugs relativ zum Oberwerkzeug auf ein Fallen unter einen Schwellenwert, z.B. $\frac{3 μ m}{1 ms}$, überwacht. Dabei liegt in einer Variante des Verfahrens der Schwellenwert dieser Momentangeschwindigkeit etwa 1 bis 4 Größenordnungen (Zehnerpotenzen) unter der zweiten Soll-Geschwindigkeit. Dabei wird in einer Variante des Verfahrens dieses Fallen unter den Schwellenwert als ein Berühren des Bauteils auf dem Substrat durch das Oberwerkzeug ausgewertet.

In einer Variante des Verfahrens wird in einer 3. Phase, während das Unterwerkzeug und das Oberwerkzeug relativ zueinander die Geschlossen-Position erreicht haben und das Berühren des Bauteils erfolgt ist, das Ansteuersignal des zweiten Antriebs, z.B. eine Ansteuerspannung des Tauchspulenaktuators, während einer vorbestimmten Press-Zeit auf einen vorbestimmten Press-Wert begrenzt. Dieser Press-Wert ist für die Kraft repräsentativ, mit der das Bauteil durch den Klebstoff auf das Substrat gedrängt wird.

In einer Variante des Verfahrens durchläuft in der 6. Phase, während das Unterwerkzeug und das Oberwerkzeug relativ zueinander die Geschlossen-Position erreicht haben und das Berühren des Bauteils erfolgt ist, das Ansteuersignal des zweiten Antriebs, z.B. eine Ansteuerspannung des Tauchspulenaktuators, während der vorbestimmten Press-Zeit ein vorbestimmtes Press-Wert-Kraft/Zeit-Profil, um die Kraft zu verändern, mit der das Bauteil durch den Klebstoff auf das Substrat gedrängt wird.

In einer Variante des Verfahrens bewegen sind in einer 7. Phase, nach dem Ablauf der vorbestimmten Press-Zeit, das Unterwerkzeug und das Oberwerkzeug relativ voneinander weg aus der Geschlossen-Position in die Offen-Position.

In einer Variante des Verfahrens wird in den 2. bis 3. Phasen ein Vergleich des Orts des Berührens des Bauteils durch das Oberwerkzeug und/oder des Ermittelns der Position des Bauteils auf dem Substrat mit einem vorbestimmten Weg- oder Positions-Wert nach Beginn des Bewegens aus der Offen-Position in die Geschlossen-Position des Oberwerkzeugs relativ zum Unterwerkzeug ausgeführt. Bei Abweichen (insbesondere Unterschreiten) des vorbestimmten Weg- oder Positions-Werts um mehr als einen vorbestimmten ersten Abweichungswert wird eine Fehlersituation detektiert. Ein Grund dafür kann sein, dass zwei Bauteile übereinander an derselben Stelle auf das Substrat platziert wurden. Ein anderer Grund kann sein, dass die Höhe eines Bauteils aus anderen Gründen, etwa einem Epitaxiefehler, von einem Erwartungswert abweicht. In der Fehlersituation wird einer Maschinensteuerung eine Fehlermeldung oder eine Unterbrechungsanforderung signalisiert. Alternativ oder zusätzlich kann bei Abweichen (insbesondere Unterschreiten) des vorbestimmten Weg- oder Positions-Werts um weniger als einen zweiten vorbestimmten Abweichungswert eine Fehlersituation zu detektieren sein. Alternativ oder zusätzlich kann bei Abweichen (insbesondere Überschreiten) des vorbestimmten Weg- oder Positions-Werts um einen vorbestimmten Abweichungswert eine Fehlersituation zu detektieren sein, weil kein Bauteil auf das Substrat platziert wurde. Auch in einer solchen Fehlersituation wird einer Maschinensteuerung eine Unterbrechungsanforderung signalisiert.

In einer Variante des Verfahrens erfasst ein Kraftsensor eine Anpresskraft zwischen dem Unterwerkzeug und dem Oberwerkzeug auf das zwischen diesen befindliche Substrat, das auf dem Substrat angeordnete Bauteil, und den zwischen das Bauteil und das Substrat eingebrachten Klebstoff zumindest in ausgewählten aufeinanderfolgender Geschlossen-Positionen des Unterwerkzeugs und des Oberwerkzeugs erfasst und an eine Steuerung signalisiert. In einer Variante des Verfahrens erfolgt eine Erfassung einer Auflagekraft nach dem Eintragen des Substrats oder eines Abschnitts des Substrats mit dem darauf angeordneten Bauteil und dem zwischen diesen eingebrachten Klebstoff zwischen das Unterwerkzeug und das Oberwerkzeug, bevor die Bewegung des Unterwerkzeugs und des Oberwerkzeugs relativ zueinander aus der Offen-Position in die Geschlossen-Position abgeschlossen ist.

In einer Variante des Verfahrens ist der Steuerung ein Indexing-Register für das Substrat zugeordnet, in dem Bestückungspositionen des Substrats einzutragen sind, auf denen ein Bauteil angeordnet ist, oder auf denen kein Bauteil angeordnet ist. Dieses Indexing-Register ist in einer Variante eine strukturierte Datei, zum Beispiel in einer Tabellenform, die durch die Steuerung positionsweise auszulesen ist. Diese Bestückungspositionen des Substrats werden vorher in dieses Indexing-Register eingetragen. Die Steuerung liest dann aus dem Indexing-Register die Bestückungspositionen des Substrats aus, auf denen ein Bauteil angeordnet ist, und steuert die jeweiligen ersten und zweiten Antriebe und die Thermode, etc. zeitgerecht so an, dass an diesen Bestückungspositionen das Verbinden des Bauteils mit dem Substrat durch Aushärten des Klebstoffs ausgeführt wird.

In einer Variante des Verfahrens liest die Steuerung aus dem Indexing-Register die Bestückungspositionen des Substrats aus, auf denen kein Bauteil angeordnet ist. An diesen Bestückungspositionen wird das Verbinden des - nicht vorhandenen - Bauteils mit dem Substrat nicht ausgeführt.

In einer Variante des Verfahrens trägt die Steuerung in das Indexing-Register für jede der Bestückungspositionen ein,
- ob die Bestückungsposition ohne Bauteil ist,
- ob an der Bestückungsposition Klebstoff vorhanden ist,
- ob an der Bestückungsposition Bauteil und Klebstoff vorhanden sind, und/oder
- sofern an der Bestückungsposition zumindest das Bauteil vorhanden ist, Position des Bauteils als X,Y-Koordinaten und dessen Rotationswinkel.

In einer Variante des Verfahrens bestimmt und veranlasst die Steuerung, sofern die Bestückungsposition ohne Bauteil ist, dass die Schritte zum Verbinden des Bauteils mit dem Substrat nicht ausgeführt werden.

In einer Variante des Verfahrens bestimmt und veranlasst die Steuerung, sofern an der Bestückungsposition Klebstoff vorhanden ist, dass das Unterwerkzeug und das Oberwerkzeug relativ zueinander in eine Zwischen-Position bewegt werden, um den Klebstoff berührungslos auszuhärten.

In einer Variante des Verfahrens bestimmt und veranlasst die Steuerung, sofern an der Bestückungsposition Bauteil und Klebstoff vorhanden sind, dass das Verbinden des Bauteils mit dem Substrat durch Aushärten des Klebstoffs ausgeführt wird.

In einer Variante des Verfahrens werden der Steuerung in das Indexing-Register für jede der Bestückungspositionen einzutragende Daten, Bildeinzüge oder aus Bildeinzügen ermittelte Metadaten zur Klebstoffaushärtung, der Bauteilpositionposition X, Y und der Bauteilrotation aus einem der Vorrichtung vorgelagerten Maschinenmodul und/oder einem der Vorrichtung vorgelagerten bildeinziehenden Inspektionssystem signalisiert, und in der Steuerung weiterverarbeitet.

In einer Variante des Verfahrens werden aus einem der Vorrichtung nachgelagerten bildeinziehenden Inspektionssystem Bildeinzüge oder aus Bildeinzügen ermittelte Metadaten zur Klebstoffaushärtung, der Bauteilpositionposition X, Y und der Bauteilrotation an die Steuerung signalisiert, damit diese durch die Steuerung weiterverarbeitet und/oder von dieser an eine nach- oder übergeordnete Prozess-Station weitergereicht werden.

Ein weiterer Aspekt, der jedoch nicht Teil der beanspruchten Erfindung ist, betrifft eine Verarbeitungsstation mit zwei oder mehr Thermokompressionsvorrichtungen, insbesondere der oben beschriebenen Art, zum Verbinden elektrischer Bauteile mit einem Substrat, das in einer oder mehreren Reihen eine Vielzahl darauf angeordneter elektrischer Bauteile trägt, wobei entweder zwei Thermokompressionsvorrichtungen dazu angeordnet und ausgerichtet sind, in einer Förderrichtung des Substrats in einer Reihe angeordnete elektrische Bauteile mit dem Substrat zu verbinden, oder zwei oder mehr Thermokompressionsvorrichtungen dazu angeordnet und ausgerichtet sind, in einer Förderrichtung des Substrats in zwei bzw. mehr Reihen angeordnete elektrische Bauteile mit dem Substrat zu verbinden, wobei die zwei oder mehr Thermokompressionsvorrichtungen entweder in einer Linie quer zur Förderrichtung benachbart zueinander angeordnet sind, oder in zwei Linien quer zur Förderrichtung im Abstand zueinander angeordnet sind, wobei der Abstand zweier Thermokompressionsvorrichtungen fest oder so veränderbar ist, dass im Wesentlichen etwa eine Reihe elektrischer Bauteile frei ist, und wobei die Thermokompressionsvorrichtungen der beiden Linien quer zur Förderrichtung um etwa eine Reihe elektrischer Bauteile zu versetzen sind.

Die beschriebene Vorrichtung / das beschriebene Verfahren sind weniger komplex; sie kommen im Vergleich zu bekannten Vorrichtungen mit wesentlich weniger Komponenten aus, sind einfacher auszuführen und erlauben mehr bearbeitete Bauteile pro Zeiteinheit. Entsprechend kann die vorliegende Vorrichtung wesentlich kostengünstiger hergestellt und betrieben werden. Diese geringere Komplexität ermöglicht weiterhin, dass die beschriebene Vorrichtung an unterschiedliche zu verarbeitende Komponenten einfach angepasst werden kann. Dadurch sind die Verarbeitung unterschiedlicher Bauteile sowie die Herstellung unterschiedlicher Baugruppen einfach realisierbar. Die neue Thermokompressionsvorrichtung löst durch ihre deutlich verkürzten Prozesszeiten eine Vielzahl alter Thermokompressionsvorrichtungen ab.

### Kurzbeschreibung der Zeichnungen

Weitere Ziele, Merkmale, Vorteile und Anwendungsmöglichkeiten ergeben sich aus der nachfolgenden Beschreibung von nicht einschränkend zu verstehenden Ausführungsbeispielen und den zugehörigen Zeichnungen.
- Fig. 1: zeigt eine schematische Frontansicht einer Thermokompressionsvorrichtung zum Verbinden von elektrischen Bauteilen mit einem Substrat.
- Fig. 2, 2a: zeigen schematische Bewegungsdiagramme der Antriebe der Thermokompressionsvorrichtung aus Fig. 1.
- Fig. 3a - 3d: zeigen schematische unterschiedliche Konfigurationen einer Verarbeitungsstation, mit einer mehr Thermokompressionsvorrichtungen für Substratbahnen mit einer oder mehreren Bauteilreihen.

### Detaillierte Beschreibung der Zeichnungen

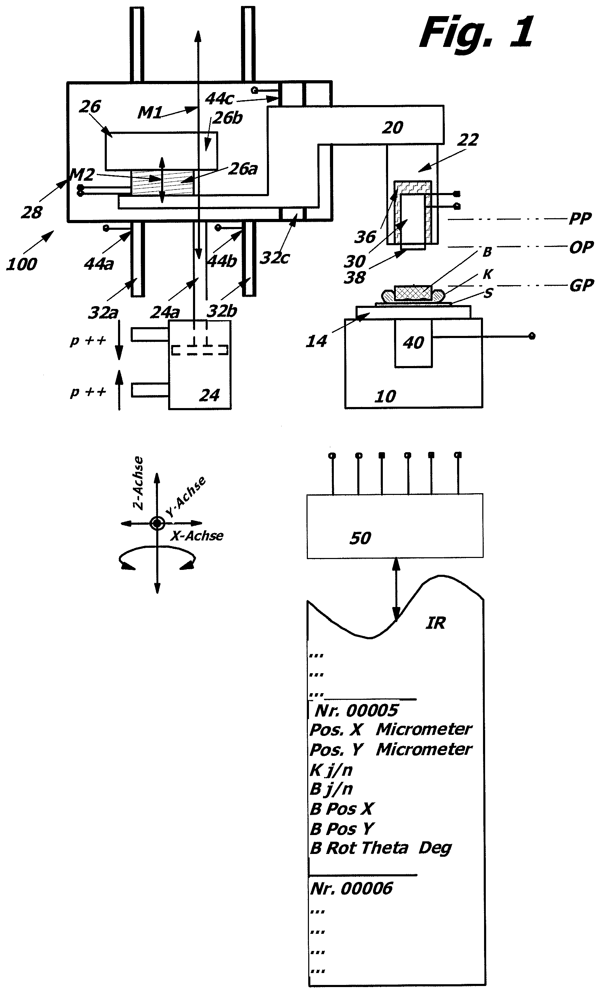

Fig. 1 zeigt den schematischen Aufbau einer Ausführungsform einer Thermokompressionsvorrichtung 100 zum Verbinden elektrischer Bauteile B mit einem Substrat S. Diese Thermokompressionsvorrichtung 100 operiert mit einem Unterwerkzeug 10 mit einer ebenen Auflagefläche 14 zum Auflegen des Substrats S mit zumindest einem darauf angeordneten elektrischen Bauteil B und einem Oberwerkzeug 20 mit einem Anpresselement 22, das der Auflagefläche 14 des Unterwerkzeugs 10 zugewandt ist. Eine Thermodenanordnung 30 dient dazu, das Bauteil B mit dem Substrat S durch thermisches Aushärten des zwischen ihnen eingebrachten Klebstoffs K fest zu verbinden.

Auf dem Substrat S sind elektrisch leitende Kontaktflächen und ggf. Leiterbahnen vorgesehen. In einem vorhergehenden Bearbeitungsschritt wurde ein Verbindungsmittel in Form eines Klebstoffs K auf das Substrat S aufgebracht. Der Klebstoff K ist flüssig und härtet thermisch aus. In einem weiteren vorhergehenden Bearbeitungsschritt wurde ein elektrisches Bauteil B, hier ein Halbleiterchip mit einem Flip-Chip-Design, auf das Substrat S und den flüssigen Klebstoff K aufgebracht. Auf der unteren Seite weist das elektrische Bauteil B elektrisch leitende Kontakte auf, welche in Kontakt mit den elektrisch leitenden Kontaktflächen des Substrats S stehen. Die Kontakte können beispielsweise die Form von metallischen Kontaktfüßen oder sogenannten "Bumps" aufweisen.

In der vorliegend veranschaulichten Variante ist das Unterwerkzeug 10 mit seiner ebenen Auflagefläche 14 zum Auflegen des Substrats S ortsfest angeordnet und das Oberwerkzeug 20 mit seinem Anpresselement 22 ist dazu beweglich. Um das Unterwerkzeug 10 und das Oberwerkzeug 20 relativ zueinander in einer Auf- / Zu-Bewegung zu bewegen, sind ein erster Antrieb 24 und ein zweiter Antrieb 26 vorgesehen.

Dabei ist der erste Antrieb 24 ist in der hier veranschaulichten Variante als pneumatischer Zylinder ausgestaltet, und der zweite Antrieb 26 ist als Tauchspulenaktuator ausgestaltet. Der erste Antrieb 24 hat einen pneumatischen Zylinder mit einer Kolbenstange 24a, die eine Armatur 28 auf- und ab bewegt, die den zweiten Antrieb 26 mit der Thermodenanordnung 30 trägt. Dazu ist die Armatur 28 in zwei Linearführungen 32a, 32b längsverschieblich geführt. Der Zylinder des ersten Antriebs 24 ist doppeltwirkend ausgestaltet. Dazu ist der in Fig. 1 obere Anschluss des Zylinders mit Überdruck p++ zu beaufschlagen um die Kolbenstange 24a entlang des Bewegungspfeils M1 abwärts zu bewegen, und der untere Anschluss des Zylinders ist mit Überdruck p++ zu beaufschlagen um die Kolbenstange 24a entlang des Bewegungspfeils M1 aufwärts zu bewegen.

Der von der Armatur 28 getragene zweite Antrieb 26 ist als Tauchspulenaktuator ausgestaltet, wobei eine zum Beispiel kreiszylindrische Tauchspule 26a in einem gegengleich gestalteten Ringspalt eines an Armatur 28 ortsfest angeordneten Permanentmagneten 26b entlang des Bewegungspfeils M2 längsbeweglich aufgenommen ist. Ein durch die Tauchspule 26a fließender Strom bestimmt durch seine Stromstärke und seine Polarität dabei die Auslenkung der Tauchspule 26a.

Die Tauchspule 26a ist mit ihrem freien, in Fig. 1 unteren Ende mit einem abgekröpften Tragarm 28a gekoppelt. Der Tragarm 28a ist an einer Linearführung 32c entsprechend der Auslenkung der Tauchspule 26a längsverschieblich geführt. Mit seinem freien, in Fig. 1 rechten Ende, welches die Armatur 28 seitlich überragt, bildet der Tragarm 28a das Oberwerkzeug 20 mit der Thermodenanordnung 30, welche dem Unterwerkzeug 10 zugewandt ist.

Abhängig z.B. von der Steifigkeit der Antriebe kann ggf. auf die Linearführungen 32a, 32b, 32c verzichtet werden.

Die Thermodenanordnung 30 hat eine auf die Dimensionen des Bauteils B abgestimmte Anpressfläche 38 für die Übertragung der Heizenergie. Die Thermodenanordnung 30 ist von der Steuerung 50 mit Strom so zu beaufschlagen, dass Heizenergie in einem Temperaturbereich von etwa 300°C bis etwa 500°C während eines Heizintervalls von etwa 0,1 bis kleiner als etwa 1 Sekunde in das Bauteil B und/oder das Substrat S einzuspeisen ist. Die Temperatur und die Zeitdauer des Heizintervalls sind so gewählt, dass der zwischen das Bauteil B und das Substrat S eingebrachte Klebstoff K thermisch aushärtet.

Die Thermodenanordnung 30 hat in dieser Variante eine kreisrunde Anpressfläche 38 für die Heizenergie mit einem an die Abmessungen des Bauteils B anzupassenden Durchmesser von weniger als etwa 5 mm. Die Thermodenanordnung 30 hat ein etwa kreiszlindrisches gestaltetes Heizelement 34, das von einen thermischen Isolierkörper 36 umfasst ist. Dabei liegt die zum Unterwerkzeug 10 hin orientierte Anpressfläche 38 frei.

Die jeweilige Auslenkung des ersten und des zweiten Antriebs 24, 26 wird durch eine Steuerung 50 in weiter unten im Detail beschriebener Weise vorgegeben. Die ersten und des zweiten Antriebe 24, 26 können dabei gleichzeitig oder nacheinander unabhängig voneinander in beide Richtungen betätigt werden. So dient in der gezeigten Variante der erste Antrieb 24 dazu, das Oberwerkzeug 20 in der ersten Bewegung M1 zwischen einer ersten Position, - Park-Position PP - und einer zweiten Position - Offen-Position OP - zu bewegen. Der zweite Antrieb 26 dient in der gezeigten Variante dazu, das Oberwerkzeug 20 in der zweiten Bewegung M2 zwischen der zweiten Position - Offen-Position OP - und einer dritten Position - Geschlossen-Position GP - zu bewegen.

Dem Unterwerkzeug 10 ist ein Kraftsensor 40 zugeordnet. Dieser Kraftsensor 40 dient dazu, eine Anpresskraft zwischen dem Unterwerkzeug 10 und dem Oberwerkzeug 20 auf das zwischen diesen befindliche Substrat S, das auf dem Substrat S angeordnete Bauteil B, und den zwischen das Bauteil B und das Substrat S eingebrachten Klebstoff K zu erfassen, wenn sich das Unterwerkzeug 10 und das Oberwerkzeug 20 in die Geschlossen-Position bewegen oder darin befinden. Ein diese Anpresskraft wiedergebender Wert oder ein entsprechendes Datentelegramm wird dann an die Steuerung 50 signalisiert. Dazu ist der Kraftsensor 40 in das Unterwerkzeug 10 integriert und erfasst durch die Auflagefläche 14 hindurch die auf ihn wirkende Kraft, welche das in die Geschlossen-Position bewegte Unterwerkzeug 10 ausübt.

In einer Variante der Vorrichtung 100 sind einer oder mehreren der Linearführungen 32a, 32b, 32c Wegsensoren 44a, 44b, 44c zugeordnet, um anstelle oder zusätzlich zu dem Kraftsensor 40 die Auswirkungen der Bewegung zwischen dem Unterwerkzeug 10 und dem Oberwerkzeug 20 auf das zwischen diesen befindliche Substrat S, das auf dem Substrat S angeordnete Bauteil B, und den zwischen das Bauteil B und das Substrat S eingebrachten Klebstoff K zu erfassen. Ein entlang der Bewegungen M1, M2 die jeweiligen Verfahrwege des ersten und/oder zweiten Antriebs 24, 26 wiedergebende Werte oder entsprechende Datentelegramme werden dann ebenfalls an die Steuerung 50 signalisiert. Dazu sind die Wegsensoren 44a, 44b, 44c in die jeweilige der Linearführungen 32a, 32b, 32c integriert und erfassen die jeweiligen Verfahrwege des ersten und/oder zweiten Antriebs 24, 26.

Basierend auf diesen Signalisierungen werden der erste Antrieb 24 und der zweite Antrieb 26 während der ersten Bewegung M1 bzw. der zweiten Bewegung M2 von der Steuerung 50 im Regelschleifenbetrieb angesteuert. Dabei dienen die Kraft- und/oder Wegmessungen als IstWerte zur Bestimmung einer Soll-Größe, insbesondere einer Weg-Position des ersten Antriebs 24 und / oder des zweiten Antriebs 26, bzw. einer Kraft resultierend aus den Bewegungen des ersten Antriebs 24 und / oder des zweiten Antriebs 26 auf das zwischen diesen befindliche Substrat S, das auf dem Substrat S angeordnete Bauteil B, und den zwischen das Bauteil B und das Substrat S eingebrachten Klebstoff K.

Der Regelschleifenbetrieb basierend auf den Kraft- und/oder Wegmessungen dient dazu, mit dem ersten Antrieb 24 die erste Bewegung M1 in einem ersten Geschwindigkeitsbereich und einem ersten Hubbereich auszuführen, und mit dem zweiten Antrieb 26 die zweite Bewegung M2 in einem zweiten Geschwindigkeitsbereich und einem zweiten Hubbereich auszuführen. Dabei ist der erste Geschwindigkeitsbereich geringer als der zweite Geschwindigkeitsbereich, und der erste Hubbereich größer als der zweite Hubbereich. Bereits vor und/oder während der Annäherung des Oberwerkzeugs 20 an das Unterwerkzeug 10 bestromt die Steuerung 50 die Thermodenanordnung 30, damit diese eine zum Aushärten des Klebstoffs erforderliche Temperatur hat. Sobald die Anpressfläche 38 sich dem Bauteil B nähert, wird in das Bauteil B und das Substrat S Heizenergie eingespeist, um den zwischen dem Bauteil B und dem Substrat S befindlichen Klebstoff K thermisch auszuhärten.

Ein Verfahren zum Betreiben einer Thermokompressionsvorrichtung 100, insbesondere einer mit den obigen Merkmalen und Eigenschaften führt folgende Schritte aus:
Auf die Auflagefläche 14 des Unterwerkzeugs 10 wird unter das Anpresselement 22 des Oberwerkzeugs 20 das Substrat S mit zumindest einem darauf angeordneten elektrischen Bauteil B aufgelegt. Dabei handelt es sich in einer Verfahrensvariante bei dem Substrat S um eine quasi-endlose Bandware mit darauf in einem vorangegangenen Verfahrensschritt aufgebrachten Bauteilen B in mehreren Reihen, die mit einem noch auszuhärtenden Klebstoff K auf dem Substrat S platziert sind. Dabei wurde der Klebstoff zeitlich vor dem Bauteil B an die für das Bauteil B vorgesehene Stelle dosiert aufgespendet.

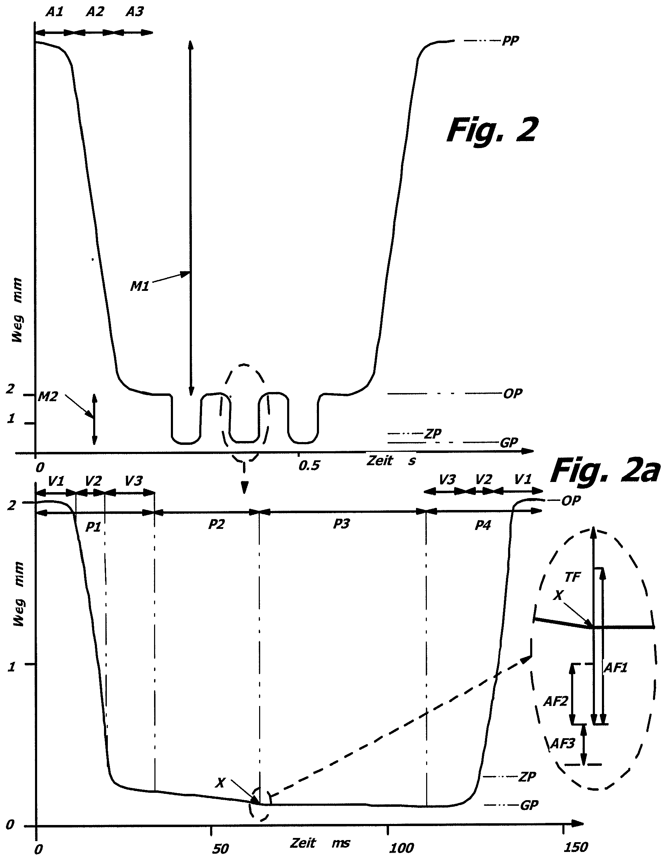

Durch den ersten Antrieb 24 und den zweiten Antrieb 26 werden das Unterwerkzeug 10 und das Oberwerkzeug 20 relativ zueinander als Auf- / Zu-Bewegung bewegt. Dabei führt der erste Antrieb 24 die erste Bewegung in dem ersten Geschwindigkeitsbereich und dem ersten Hubbereich aus. Der zweite Antrieb 26 führt die zweite Bewegung in dem zweiten Geschwindigkeitsbereich und dem zweiten Hubbereich aus. Der erste Geschwindigkeitsbereich ist geringer als der zweite Geschwindigkeitsbereich, und der erste Hubbereich ist größer als der zweite Hubbereich. Dies ist in Fig. 2 veranschaulicht.

Während zumindest eines Teils der Auf- / Zu-Bewegung speist die von dem Oberwerkzeug 20 getragene, und dem Anpresselement 22 zugeordnete Thermodenanordnung 30 in das Bauteil B und/oder das Substrat S Heizenergie ein, um den zwischen das Bauteil B und das Substrat S eingebrachten Klebstoff K thermisch auszuhärten.

Fig. 2 veranschaulicht weiter, wie der erste Antrieb 24 das Oberwerkzeug 20 in der ersten Bewegung M1 zu dem ortsfesten Unterwerkzeug 10 zwischen der ersten Position PP und der zweiten Position OP bewegt. Der zweite Antrieb 26 bewegt dann das Oberwerkzeug 20 in der zweiten - oszillierenden - Bewegung M2 zwischen der zweiten Position OP und der dritten Position GP relativ zu dem Unterwerkzeug 10. Die erste Position ist die Park-Position PP, die zweite Position ist die Offen-Position OP, und die dritte Position ist die Geschlossen-Position GP. In der hier gezeigten Variante führen der erste Antrieb 24 und der zweite Antrieb 26 die erste Bewegung M1und die zweite Bewegung M2 nacheinander aus. In Fig. 2 ist die oszillierend wiederholte zweite Bewegung M2 des Oberwerkzeugs 20 zwischen der zweiten Position OP und der dritten Position GP relativ zu dem Unterwerkzeug 10 dargestellt. Diese Bewegung dient dazu, die auf dem als Bandware gestalteten Substrat S befindlichen Bauteile, genauer gesagt den zwischen den Bauteilen B und dem Substrat S befindlichen Klebstoff K, kontinuierlich oder intermittierend zwischen der Auflagefläche 14 und dem Anpresselement 22 des Unterwerkzeugs 10 bzw. des Oberwerkzeugs 20 in deren Offen-Position OP hindurch zu fördern, und in deren Geschlossen-Position GP mit Heizenergie zu beaufschlagen.

Fig. 2a veranschaulicht den Ablauf einer Abfolge Schließen-Heizen-Öffnen aus Fig. 2 im Detail.

Zunächst führt der erste Antrieb 24 die erste Bewegung M1 soweit aus, dass das Oberwerkzeug 20 aus der Park-Position PP kommend zusammen mit dem Unterwerkzeug 10 die Offen-Position OP (Höhe 2 mm in Fig. 2a) eingenommen hat. Dabei hat die erste Bewegung M1 einen Beschleunigungs-Abschnitt A1, einen Schnellfahrt-Abschnitt A2, und einen Verzögerungs-Abschnitt A3 (siehe Fig. 2).

In einer 1. Phase P1 beginnt der zweite Antrieb 26 die zweite Bewegung M2 auszuführen, damit sich das Oberwerkzeug 20 aus der Offen-Position OP auf das Unterwerkzeug 10 zubewegt, um die Geschlossen-Position GP einzunehmen. Dabei hat die zweite Bewegung M2 einen Beschleunigungs-Abschnitt V1, einen Schnellfahrt-Abschnitt V2, und einen Verzögerungs-Abschnitt V3 (siehe Fig. 2a).

In dem Beschleunigungs-Abschnitt V1 beschleunigt der zweite Antrieb 26 zum Ausführen der zweiten Bewegung M2 solange, bis eine vorbestimmte erste Soll-Geschwindigkeit, hier nahezu 200 mm/s erreicht ist, mit der sich das Unterwerkzeug 10 und das Oberwerkzeug 20 aus der Offen- OP in die Geschlossen-Position GP relativ zueinander bewegen (siehe Fig. 2a).

In dem Verzögerungsabschnitt V3 der 1. Phase verzögert der zweite Antrieb 26 zum Ausführen der zweiten Bewegung M2 diese solange, bis eine vorbestimmte zweite, geringere als die erste Soll-Geschwindigkeit, hier etwa 5 mm/s erreicht ist, mit der sich das Oberwerkzeug 20 aus der Offen-Position OP in die Geschlossen-Position GP auf das Unterwerkzeug 10 zu bewegt. Mit dieser geringeren zweiten Soll-Geschwindigkeit bewegt sich dann das Oberwerkzeug 20 weiter, um mit dieser das Bauteil B und/oder eine Position des Bauteils B auf dem Substrat S zu erkennen.

Während sich das Oberwerkzeug 20 durch den zweiten Antrieb 26 zum Ausführen der zweiten Bewegung M2 mit der zweiten, geringeren Soll-Geschwindigkeit aus der Offen-Position OP in die Geschlossen-Position GP auf das Unterwerkzeug 10 zu bewegt, wird in einer 2. Phase P2, um durch Berühren des Bauteils B dieses und/oder dessen Position auf dem Substrat S zu ermitteln, ein Ansteuersignal des zweiten Antriebs 26, hier die Ansteuerspannung des Tauchspulenaktuators, auf einen vorbestimmten Maximalwert begrenzt. Diese Langsamfahrt, verbunden mit der aus der verringerten Kraft des Tauchspulenaktuators vermeidet bei einem Auftreffen des Anpresselements 22 des Oberwerkzeugs 20 auf dem Bauteil B dessen Beschädigung.

Während sich das Oberwerkzeug 20 durch den zweiten Antrieb 26 zum Ausführen der zweiten Bewegung M2 mit der zweiten, geringeren Soll-Geschwindigkeit aus der Offen-Position OP in die Geschlossen-Position GP auf das Unterwerkzeug 10 zu bewegt, um das Bauteil B und/oder dessen Position auf dem Substrat S zu erkennen, wird fortlaufend eine Momentangeschwindigkeit $\frac{Δ s}{Δ t}$ des Oberwerkzeugs 20 relativ zum Unterwerkzeug 10 auf ein Fallen unter einen Schwellenwert, z.B. $\frac{3 μ m}{1 ms}$, überwacht. Dieser Schwellenwert liegt deutlich (zum Beispiel zwischen 1 und 4 Größenordnungen unter der zweiten Soll-Geschwindigkeit). Sobald die Momentangeschwindigkeit $\frac{Δ s}{Δ t}$ der Bewegung M2 des Oberwerkzeugs 20 unter diesen Schwellenwert fällt, wird in der Steuerung erkannt, dass das Bauteil B auf dem Substrat S durch das Oberwerkzeug 10 berührt wurde. Dies ist in der Fig. 2a als X "Berührung" gekennzeichnet.

Während das Unterwerkzeug 10 und das Oberwerkzeug 20 die Geschlossen-Position GP einhalten und das Berühren des Bauteils B - unter Heizeinwirkung der Thermodenanordnung 30 auf das Bauteil B und den darunter befindlichen Klebstoff K - erfolgt, wird das Ansteuersignal des zweiten Antriebs 26, hier die Ansteuerspannung des Tauchspulenaktuators, begrenzt. In dieser 3. Phase P3, einer vorbestimmten Press-Zeit, wird das Ansteuersignal des zweiten Antriebs 26 auf einen vorbestimmten Press-Wert begrenzt, der für die Kraft repräsentativ ist, mit der das Bauteil B durch den Klebstoff K auf das Substrat S gedrängt wird. In dieser Zeit härtet durch die Heizeinwirkung und die auf das Bauteil B wirkende Kraft der Klebstoff K aus.

In dieser 3. Phase P3 ist in der in Fig. 2a veranschaulichten Verfahrensvariante die Kraft konstant, mit der das Bauteil B durch den Klebstoff K auf das Substrat S gedrängt wird. In einer hier nicht weiter veranschaulichten Verfahrensvariante durchläuft die Kraft, mit der das Bauteil B durch den Klebstoff K auf das Substrat S gedrängt wird, während der vorbestimmten Press-Zeit ab der Berührung des Bauteils B durch das Oberwerkzeug bis zu dessen Abheben von dem Bauteil B ein vorbestimmtes Press-Wert-Kraft/Zeit-Profil gemäß dem das Bauteil B in den Klebstoff K hinein auf das Substrat S gedrängt wird.

In einer 4. Phase P4, nach dem Ablauf der vorbestimmten Press-Zeit in der 3. Phase P3, werden das Unterwerkzeug 10 und das Oberwerkzeug 20 durch den zweiten Antrieb 26 zum Ausführen der zweiten Bewegung M2 relativ voneinander weg aus der Geschlossen-Position GP in die Offen-Position OP bewegt.

In den 2. und 3. Phasen P2, P3 wird durch die Steuerung ein Vergleich des Orts X des Berührens des Bauteils B durch das Oberwerkzeug 20 (genauer gesagt, des Anpresselements 22) und/oder des Ermittelns der Position (oder der Höhe der Oberseite) des Bauteils B auf dem Substrat S mit einem vorbestimmten Weg- oder Positions-Wert TF nach Beginn des Bewegens aus der Offen-Position OP in die Geschlossen-Position GP ausgeführt. Der Weg- oder Positions-Wert TF legt damit einen Höhen- oder Wegbereich fest, indem der Kontakt des Anpresselements 22 mit der Oberseite des Bauteils B auftreten soll. Bei Unterschreiten des vorbestimmten Weg- oder Positionswerts TF um mehr als einen vorbestimmten ersten Abweichungswert AF1 wird eine Fehlersituation detektiert, weil zum Beispiel zwei Bauteile B übereinander an derselben Stelle auf das Substrat S platziert wurden, oder die Höhe eines Bauteils S aus anderen Gründen, etwa einem Epitaxiefehler des Bauteils B, von einem Erwartungswert abweicht. Daraufhin wird einer (übergeordneten) Maschinensteuerung eine Fehlermeldung oder eine Unterbrechungsanforderung signalisiert.

Zusätzlich wird bei Unterschreiten des vorbestimmten Weg- oder Positionswerts TF um weniger als einen zweiten vorbestimmten Abweichungswert AF2 eine Fehlersituation detektiert, oder bei Überschreiten des vorbestimmten Weg- oder Positionswerts TF um einen vorbestimmten dritten Abweichungswert AF3 eine Fehlersituation detektiert, weil kein Bauteil B auf das Substrat B platziert wurde. Daraufhin wird einer (übergeordneten) Maschinensteuerung eine Fehlermeldung oder eine Unterbrechungsanforderung signalisiert. Dies soll verhindern, dass die Thermodenanordnung 30 oder die Anpressfläche 22 den Klebstoff K oder das Substrat S berührt, da dies zu einer Verschmutzung der Anpressfläche 22 der Thermodenanordnung 30 bzw. zu Brandlöchern im Substrat S führen könnte. Erkennt die Steuerung 50, dass wegen des fehlenden Bauteils B ein Aufsetzen auf den Klebstoff K oder das Substrat S bevorsteht, stoppt das Oberwerkzeug 20 die Thermodenanordnung 30 und fährt sie an eine zurückgezogene Sicherheitsposition ZP, die in der Nähe der zu erwartenden X "Berührung"-Position liegt und verweilt dort für einen längeren Zeitraum. Dies dient dem berührungslosen Härten von eventuell vorhandenem Klebstoff K.

Nach Ablauf dieses Zeitraums fährt das Oberwerkzeug in der 4. Phase P4 die Thermodenanordnung 30 in inverser Weise wie in der ersten Phase P1 zur Offen-Position OP zurück. Von dort beginnt ein neuer Zyklusstart mit der ersten Phase P1. Das Substrat S kann während dessen weiter transportiert werden, um ein nachfolgendes Bauteil zwischen Ober- und Unterwerkzeug zu positionieren.

Durch die langsame Suchgeschwindigkeit während der 2. Phase kann es bei einer unzureichend vorherbestimmten Suchposition zu sehr langen Verzögerungen bis zur X "Berührung" kommen. Die Folge wäre ein stark verlangsamter Maschinenzyklus. Außerdem unterliegt die Thermodenanordnung in der Aufheizphase auch einer Längenänderung. Wurde die X "Berührung"-Position im kalten Zustand vermessen und die zu erwartende Längenänderung nicht berücksichtigt, kann dies zu einer verfrühten Berührung der Oberfläche des Bauteils durch das Oberwerkzeug führen. Beide Aspekte werden durch diese oben beschriebene Vorgehensweise während des Betriebes durch die Regelschleife in der Steuerung ausgeregelt. Ziel der Regelung ist hier eine möglichst kurze Suchphase zu erzielen um einen hohen Durchsatz zu erreichen.

In einer Verfahrensvariante erfasst ein Kraftsensor 40 eine Anpresskraft zwischen dem Unterwerkzeug 10 und dem Oberwerkzeug 20 auf das zwischen diesen befindliche Substrat S, das darauf angeordnete Bauteil B, und den zwischen ihnen eingebrachten Klebstoff K, wenn sich das Unterwerkzeug 10 und das Oberwerkzeug 20 in die Geschlossen-Position bewegen und darin verbleiben. Die erfasste Anpresskraft wird an die Steuerung 50 signalisiert. Bevor die Bewegung des Unterwerkzeugs 10 und des Oberwerkzeugs 20 relativ zueinander aus der Offen-Position OP in die Geschlossen-Position GP abgeschlossen ist, und noch keine Anpresskraft ausgeübt wird, erfolgt eine Erfassung einer Auflagekraft TARA nach dem Eintragen des Substrats S oder eines Abschnitts des Substrats S mit dem darauf angeordneten Bauteil B und dem zwischen diesen eingebrachten Klebstoff K. Das Substrat S lastet auf dem Kraftsensor 40. Deshalb erlaubt das Erfassen der Auflagekraft TARA ein Kompensieren eines aus einer schwankenden Spannung des Substrats S in Förderrichtung resultierenden Einflusses auf das Messergebnis der Kraftmessung. Diese TARA Funktion wird nach dem Fördern des Substrats S, so dass das Bauteil B direkt über dem Kraftsensor 40 positioniert ist, und vor dem Auftreffen der Thermodenanordnung 30 aktiviert.

In einer Verfahrensvariante ist der Steuerung 50 ein Indexing-Register IR für das Substrat S zugeordnet. In das Indexing-Register IR sindBestückungspositionen des Substrats S einzutragen, auf denen ein Bauteil B angeordnet ist, oder auf denen kein Bauteil B angeordnet ist. Dieses Eintragen erfolgt entweder durch eine externe Datenquelle oder durch die Steuerung 50, mit von außen entsprechend zugelieferten Daten.

In einer nicht weiter bildlich veranschaulichten Variante der Steuerung 50 werden in das Indexing-Register IR für jede der Bestückungspositionen einzutragende Daten, Bildeinzüge oder aus Bildeinzügen ermittelte Metadaten zur Klebstoffaushärtung, der Bauteilposition Position X, Y und der Bauteilrotation aus einem der Vorrichtung 100 vorgelagerten Maschinenmodul und/oder einem der Vorrichtung 100 vorgelagerten bildeinziehenden Inspektionssystem IS signalisiert, und in der Steuerung 50 für den Betrieb der Vorrichtung 100 weiterverarbeitet.

In einer weiteren nicht weiter bildlich veranschaulichten Variante der Steuerung 50 werden aus einem der Vorrichtung 100 nachgelagerten bildeinziehenden Inspektionssystem Bildeinzüge oder aus Bildeinzügen ermittelte Metadaten zur Klebstoffaushärtung, der Bauteilposition Position X, Y und der Bauteilrotation signalisiert, damit diese weiterverarbeitet und/oder an eine nach- oder übergeordnete Prozess-Station weitergereicht werden.

Die Steuerung 50 liest beim Ausführen der Klebstoff-Aushärtungsvorgänge aus dem Indexing-Register IR die jeweiligen Bestückungspositionen Pos X, Pos Y des Substrats S aus, auf denen ein Bauteil B angeordnet ist. An diesen Bestückungspositionen wird dann das Verbinden des Bauteils B mit dem Substrat S durch Aushärten des Klebstoffs K in oben beschriebener Weise ausgeführt. Im Übrigen trägt in einer Variante die Steuerung 50 oder die externe Datenquelle in das Indexing-Register IR für jede der Bestückungspositionen auch ein, ob die Bestückungsposition ohne Bauteil B j/n ist, ob an der Bestückungsposition Klebstoff K j/n vorhanden ist, und ob an der Bestückungsposition Bauteil und Klebstoff vorhanden sind, und/oder sofern an der Bestückungsposition zumindest das Bauteil B vorhanden ist, die Position des Bauteils B als X-, Y-Koordinaten und dessen Rotationswinkel THETA. Soweit die Steuerung 50 aus dem Indexing-Register IR die Bestückungspositionen des Substrats S ausliest, auf denen kein Bauteil B angeordnet ist, also B j/n = n, wird an diesen Bestückungspositionen das Verbinden des Bauteils B mit dem Substrat S durch Aushärten des Klebstoffs K nicht ausgeführt.

Soweit die Steuerung 50 aus dem Indexing-Register IR die Bestückungspositionen des Substrats S ausliest, auf denen kein Bauteil B angeordnet ist, also B j/n = n, aber Klebstoff vorhanden ist, also K j/n = j, wird an diesen Bestückungspositionen das Verbinden des Bauteils B mit dem Substrat S durch Aushärten des Klebstoffs K nicht ausgeführt, werden das Unterwerkzeug 10 und das Oberwerkzeug 20 relativ zueinander in eine Zwischen-Position ZP bewegt. Dort wird bei Abstand zwischen der Thermodenanordnung 30 und dem Klebstoff K dieser berührungslos ausgehärtet.

Ansonsten wird die Steuerung 50, sofern an der Bestückungsposition das Bauteil B und der Klebstoff K vorhanden sind, das Verbinden des Bauteils B mit dem Substrat S durch Aushärten des Klebstoffs K ausgeführt.

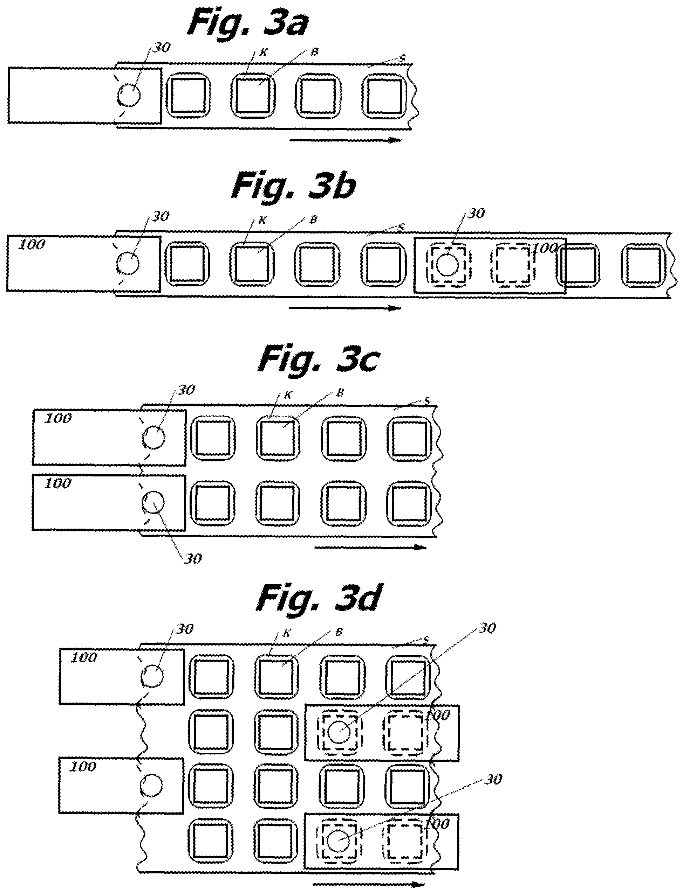

Die Fig. 3a - 3d zeigen unterschiedliche Konfigurationen einer Verarbeitungsstation, wobei die Verarbeitungsstationen mit zwei oder mehr Thermokompressionsvorrichtungen 100 zum Verbinden elektrischer Bauteile B mit dem Substrat S konzipiert sind, das in einer oder mehreren Reihen eine Vielzahl darauf angeordneter elektrischer Bauteile B trägt.

Die Fig. 3a veranschaulicht in einer Draufsicht eine Verarbeitungsstation mit der Konfiguration der Fig. 1, wobei eine endlose Substratbahn eine Reihe mit Bauteilen trägt, die durch eine Thermokompressionsvorrichtung 100 zu bearbeiten sind.

Die Fig. 3b veranschaulicht in einer Draufsicht eine Verarbeitungsstation mit zwei Thermokompressionsvorrichtungen 100. Diese zwei Thermokompressionsvorrichtungen 100 bearbeiten eine endlose Substratbahn mit einer Reihe mit Bauteilen. Dabei sind die beiden Thermokompressionsvorrichtungen 100 spiegelbildlich und im Abstand zueinander entlang der Substratbahn angeordnet.

Die Fig. 3c veranschaulicht in einer Draufsicht eine Verarbeitungsstation mit der in der Breite der Substratbahn verdoppelten Konfiguration der Fig. 3a, wobei die Substratbahn zwei parallele Reihen mit Bauteilen trägt, von denen jede durch eine der beiden Thermokompressionsvorrichtungen 100 zu bearbeiten ist. Hierbei sind die zwei Thermokompressionsvorrichtungen 100 in einer Linie quer zur Förderrichtung der Substratbahn benachbart zueinander angeordnet.

Die Fig. 3d veranschaulicht in einer Draufsicht eine Verarbeitungsstation mit der in der Breite der Substratbahn vervierfachten Konfiguration der Fig. 3a, wobei die Substratbahn vier parallele Reihen mit Bauteilen trägt, von denen jede durch eine der vier Thermokompressionsvorrichtungen 100 zu bearbeiten ist. Dabei sind die vier Thermokompressionsvorrichtungen 100 in der Förderrichtung in zwei Linien quer zur Förderrichtung im Abstand zueinander angeordnet sind, wobei der Abstand zweier Thermokompressionsvorrichtungen 100 so festgestellt ist, dass im Wesentlichen zwischen zwei benachbarten Thermokompressionsvorrichtungen 100 (z.B. der in Fig. 3d obersten und der in der 3. Reihe) etwa eine Reihe elektrischer Bauteile B frei ist. Die Thermokompressionsvorrichtungen 100 der beiden Linien (in Fig. 3d bilden die Thermokompressionsvorrichtungen 100 der obersten und der 3. Reihe eine Linie, und die die Thermokompressionsvorrichtungen 100 der untersten und der 2. Reihe eine Linie quer zur Förderrichtung sind jeweils um etwa eine Reihe elektrischer Bauteile B versetzt. Diese versetzte Anordnung wird bei Bauteil-Reihenabständen verwendet, die kleiner als die doppelte Breite einer Thermokompressionsvorrichtung sind.

Die vorangehend beschriebenen Varianten der Vorrichtung sowie deren Aufbau- und Betriebsaspekte dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen.

## Patentansprüche

1. Thermokompressionsvorrichtung (100) zum Verbinden elektrischer Bauteile (B) mit einem Substrat (S), mit
einem Unterwerkzeug (10) mit einer Auflagefläche (14) zum Auflegen des Substrats (S) mit zumindest einem darauf angeordneten elektrischen Bauteil (B) und
einem Oberwerkzeug (20) mit einem Anpresselement (22), das der Auflagefläche (14) des Unterwerkzeugs (10) zugewandt ist, wobei
das Unterwerkzeug (10) und das Oberwerkzeug (20) relativ zueinander in einer Auf- / Zu-Bewegung bewegbar sind, wobei
das Unterwerkzeug (10) und/oder das Oberwerkzeug (20) dazu eingerichtet sind,
die Auf- / Zu-Bewegung durch einen ersten Antrieb (24) und einen zweiten Antrieb (26) auszuführen, wobei
der erste Antrieb (24) dazu eingerichtet ist, eine erste Bewegung (M1) in einem ersten Hubbereich auszuführen, wobei die erste Bewegung (M1) einen Beschleunigungs-Abschnitt (A1) und einen Schnellfahrt-Abschnitt (A2) und einen Verzögerungsabschnitt (A3) hat; und
der zweite Antrieb (26) dazu eingerichtet ist, eine zweite Bewegung (M2) in einem zweiten Hubbereich auszuführen, wobei die zweite Bewegung (M2) einen Beschleunigungs-Abschnitt (V1) und einen Schnellfahrt-Abschnitt (V2) und einen Verzögerungsabschnitt (V3) hat; und wobei
eine Bewegungsgeschwindigkeit während des Schnellfahrt-Abschnitts (A2) der ersten Bewegung (M1) geringer ist als eine Bewegungsgeschwindigkeit während des Schnellfahrt-Abschnitts (V2) der zweiten Bewegung (M2); und
der erste Hubbereich größer als der zweite Hubbereich ist; und wobei
das Unterwerkzeug (10) oder das Oberwerkzeug (20) eine der Auflagefläche (14) und/oder dem Anpresselement (22) zugeordnete Thermodenanordnung (30) trägt, die dazu eingerichtet ist, in das Bauteil (B) und/oder das Substrat (S) Heizenergie einzuspeisen, um einen zwischen das Bauteil (B) und das Substrat (S) eingebrachten Klebstoff (K) thermisch auszuhärten.

2. Thermokompressionsvorrichtung (100) nach Anspruch 1, wobei
der erste Antrieb (24) dazu eingerichtet ist, das Unterwerkzeug (10) oder das Oberwerkzeug (20) in der ersten Bewegung zwischen einer ersten Position und einer zweiten Position zu bewegen; und
der zweite Antrieb (26) dazu eingerichtet ist, das Unterwerkzeug (10) oder das Oberwerkzeug (20) in der zweiten Bewegung zwischen der zweiten Position und einer dritten Position zu bewegen; wobei vorzugsweise
die erste Position eine Park-Position (PP), die zweite Position eine Offen-Position (OP), und die dritte Position eine Geschlossen-Position (GP) ist; und/oder wobei
der erste Antrieb (24) und der zweite Antrieb (26) dazu eingerichtet und anzusteuern sind, die erste Bewegung und die zweite Bewegung entweder nacheinander oder zeitlich einander überlappend auszuführen.

3. Thermokompressionsvorrichtung (100) nach Anspruch 1 oder 2, wobei
der erste Antrieb (24) und der zweite Antrieb (26) dazu eingerichtet sind, gleichsinnig oder gegensinnig zu wirken, um die Auf- / Zu-Bewegung des Unterwerkzeugs (10) und des Oberwerkzeugs (20) zu bewirken; und/oder
wobei der erste Antrieb (24) und der zweite Antrieb (26) entweder
beide dem Unterwerkzeug (10) oder dem Oberwerkzeug (20) zugeordnet sind; oder
einer der beiden Antriebe (24, 26) dem Unterwerkzeug (10) und der andere der beiden Antriebe (24, 26) dem Oberwerkzeug (20) zugeordnet ist; und/oder
wobei die Thermodenanordnung (30) dazu eingerichtet und anzusteuern ist, in das Bauteil (B) und/ oder das Substrat (S) Heizenergie in einem Temperaturbereich von etwa 300°C bis etwa 500°C während eines Heizintervalls von etwa 0,07 bis etwa 1,5 Sekunden, oder etwa 0,1 bis kleiner als etwa 1 Sekunde einzuspeisen, um den zwischen das Bauteil (B) und das Substrat (S) eingebrachten Klebstoff (K) thermisch auszuhärten; und/oder wobei
die Thermodenanordnung (30) eine Anpressfläche (38) für die Heizenergie von etwa kreisrunder Gestalt und einem Durchmesser von weniger als etwa 5 mm hat; und/oder wobei
die Thermodenanordnung (30) einen thermischen Isolierkörper umfasst, der ein zu bestromendes Heizelement (34) nahezu vollständig umgibt, wobei zumindest die Anpressfläche (38) freiliegt; und/oder
wobei dem Unterwerkzeug (10) und/oder dem Oberwerkzeug (20) ein Kraftsensor (40) zugeordnet ist, der dazu eingerichtet ist, eine Anpresskraft zwischen dem Unterwerkzeug (10) und dem Oberwerkzeug (20) auf das zwischen diesen befindliche Substrat (S), das auf dem Substrat (S) angeordnete Bauteil (B), und den zwischen das Bauteil (B) und das Substrat (S) eingebrachten Klebstoff (K) zumindest in ausgewählten aufeinanderfolgender Geschlossen-Positionen des Unterwerkzeugs (10) und des Oberwerkzeugs (20) zu erfassen und an eine Steuerung (50) zu signalisieren; und/oder wobei der erste Antrieb (24) als pneumatischer oder hydraulischer Zylinder ausgestaltet ist, und der zweite Antrieb (26) als Tauchspulenaktuator ausgestaltet ist; und/oder
wobei der erste Antrieb (24) und / oder der zweite Antrieb (26) während der ersten Bewegung (M1) bzw. der zweiten Bewegung (M2) von der Steuerung (50) im Regelschleifenbetrieb angesteuert werden, wobei eine Kraft- und/oder Wegmessung zur Bestimmung einer Soll-Größe, insbesondere einer Weg-Position des ersten Antriebs (24) und / oder des zweiten Antriebs (26) verwendet wird oder einer Kraft auf das zwischen diesen befindliche Substrat (S), das auf dem Substrat (S) angeordnete Bauteil (B), und den zwischen das Bauteil (B) und das Substrat (S) eingebrachten Klebstoff (K).

4. Verfahren zum Betreiben einer Thermokompressionsvorrichtung (100) zum Verbinden elektrischer Bauteile (B) mit einem Substrat (S) nach einem oder mehreren der Ansprüche 1 bis 3, mit den Schritten:
Auflegen des Substrats (S) mit zumindest einem darauf angeordneten elektrischen Bauteil (B) auf eine Auflagefläche (14) des Unterwerkzeugs (10) unter ein Anpresselement (22) eines Oberwerkzeugs (20);
Bewegen des Unterwerkzeugs (10) und des Oberwerkzeugs (20) relativ zueinander in einer Auf- / Zu-Bewegung durch einen ersten Antrieb (24) und einen zweiten Antrieb (26); wobei
der erste Antrieb (24) eine erste Bewegung (M1) in einem ersten Hubbereich ausführt, wobei die erste Bewegung (M1) einen Beschleunigungs-Abschnitt (A1) und einen Schnellfahrt-Abschnitt (A2) und einen Verzögerungsabschnitt (A3) hat; und
der zweite Antrieb (26) eine zweite Bewegung in einem zweiten Hubbereich ausführt, wobei die zweite Bewegung (M2) einen Beschleunigungs-Abschnitt (V1) und einen Schnellfahrt-Abschnitt (V2) und einen Verzögerungsabschnitt (V3) hat; und wobei
eine Bewegungsgeschwindigkeit während des Schnellfahrt-Abschnitts (A2) der ersten Bewegung (M1) geringer ist als eine Bewegungsgeschwindigkeit während des Schnellfahrt-Abschnitts (V2) der zweiten Bewegung (M2); und
der erste Hubbereich größer als der zweite Hubbereich ist; und wobei
das Unterwerkzeug (10) oder das Oberwerkzeug (20) eine der Auflagefläche (14) bzw. dem Anpresselement (22) zugeordnete Thermodenanordnung (30) trägt, die dazu eingerichtet ist, während zumindest eines Teils der Auf- / Zu-Bewegung in das Bauteil (B) und/oder das Substrat (S) Heizenergie einzuspeisen, um einen zwischen das Bauteil (B) und das Substrat (S) eingebrachten Klebstoff (K) thermisch auszuhärten.

5. Verfahren zum Betreiben einer Thermokompressionsvorrichtung (100) nach Anspruch 4, wobei
der erste Antrieb (24) das Unterwerkzeug (10) oder das Oberwerkzeug (20) in der ersten Bewegung zwischen einer ersten Position und einer zweiten Position relativ zueinander bewegt; und
der zweite Antrieb (26) das Unterwerkzeug (10) oder das Oberwerkzeug (20) in der zweiten Bewegung zwischen der zweiten Position und einer dritten Position relativ zueinander bewegt; wobei vorzugsweise
die erste Position eine Park-Position (PP), die zweite Position eine Offen-Position (OP), und die dritte Position eine Geschlossen-Position (GP) ist, und/oder wobei
der erste Antrieb (24) und der zweite Antrieb (26) die erste Bewegung (M1) und die zweite Bewegung (M2) entweder nacheinander oder zeitlich einander überlappend ausführen; und/oder
wobei das Substrat (S) mit dem Bauteil (B) und dem Klebstoff (K) kontinuierlich und/oder intermittierend zwischen der Auflagefläche (14) und dem Anpresselement (22) des Unterwerkzeugs (10) bzw. des Oberwerkzeugs (20) in der Offen-Position des Unterwerkzeugs (10) und des Oberwerkzeugs (20) hindurch gefördert werden; und/oder
wobei in einer 1. Phase (P1), nachdem der erste Antrieb (24) die erste Bewegung (M1) soweit ausgeführt hat, dass sich das Unterwerkzeug (10) und das Oberwerkzeug (20) aus der Park-Position (PP) in die Offen-Position (OP) bewegt haben, der zweite Antrieb (26) die zweite Bewegung (M2) auszuführen beginnt, damit sich das Unterwerkzeug (10) und das Oberwerkzeug (20) aus der Offen-Position (OP) in die Geschlossen-Position (GP) relativ zueinander bewegen; und/oder
wobei in dem Beschleunigungsabschnitt (V1), der zweite Antrieb (26) zum Ausführen der zweiten Bewegung (M2) solange beschleunigt, bis eine vorbestimmte erste Soll-Geschwindigkeit, z.B. 100 mm/s bis 300 mm/s, z.B. 200 mm/s, erreicht ist, mit der sich das Unterwerkzeug (10) und das Oberwerkzeug (20) aus der Offen-Position (OP) in die Geschlossen-Position (GP) relativ zueinander bewegen; und/oder
wobei in dem Verzögerungsabschnitt (V3) der zweite Antrieb (26) zum Ausführen der zweiten Bewegung solange, bis eine vorbestimmte zweite, geringere als die erste Soll-Geschwindigkeit, z.B. 2 mm/s bis 20 mm/s, z.B. 5 mm/s, erreicht ist, mit der sich das Unterwerkzeug (10) und das Oberwerkzeug (20) aus der Offen-Position (OP) in die Geschlossen-Position (GP) relativ zueinander bewegen; und/oder
wobei in einer 2. Phase (P2), welche sich an den Verzögerungsabschnitt (V3) der zweite Bewegung (M2) anschließt, während sich das Unterwerkzeug (10) und das Oberwerkzeug (20) aus der Offen-Position (OP) in die Geschlossen-Position (GP) relativ zueinander bewegen,
- um durch Berühren des Bauteils (B) das Bauteil (B) und/oder dessen Position auf dem Substrat (S) zu ermitteln, ein Ansteuersignal des zweiten Antriebs (26), z.B. eine Ansteuerspannung des Tauchspulenaktuators, auf einen vorbestimmten Maximalwert begrenzt wird, um bei einem Auftreffen des Anpresselements (22) des Oberwerkzeugs (20) auf dem Bauteil (B) dieses nicht zu beschädigen; und/oder
- um das Bauteil (B) und/oder dessen Position auf dem Substrat (S) zu erkennen, fortlaufend oder intermittierend eine Momentangeschwindigkeit $\frac{Δ s}{Δ t}$ des Unterwerkzeugs (10) relativ zum Oberwerkzeug (20) auf ein Fallen unter einen Schwellenwert, z.B. $\frac{3 μ m}{1 ms}$, überwacht wird, wobei der Schwellenwert zwischen 1 und 4 Größenordnungen unter der zweiten Soll-Geschwindigkeit liegt, und wobei dieses Fallen unter den Schwellenwert als ein Berühren des Bauteils (B) auf dem Substrat (S) durch das Oberwerkzeug (10) ausgewertet wird.

6. Verfahren zum Betreiben einer Thermokompressionsvorrichtung (100) nach Anspruch 5, wobei
in einer 3. Phase (P3), während das Unterwerkzeug (10) und das Oberwerkzeug (20) relativ zueinander die Geschlossen-Position (GP) erreicht haben und das Berühren des Bauteils (B) erfolgt ist, das Ansteuersignal des zweiten Antriebs (26), z.B. eine Ansteuerspannung des Tauchspulenaktuators, während einer vorbestimmten Press-Zeit auf einen vorbestimmten Press-Wert begrenzt wird, der für die Kraft repräsentativ ist, mit der das Bauteil (B) durch den Klebstoff (K) auf das Substrat (S) gedrängt wird.

7. Verfahren zum Betreiben einer Thermokompressionsvorrichtung (100) nach Anspruch 6, wobei
in der 3. Phase (P3), während das Unterwerkzeug (10) und das Oberwerkzeug (20) relativ zueinander die Geschlossen-Position (GP) erreicht haben und das Berühren des Bauteils (B) erfolgt ist, das Ansteuersignal des zweiten Antriebs (26), z.B. eine Ansteuerspannung des Tauchspulenaktuators, während der vorbestimmten Press-Zeit ein vorbestimmtes Press-Wert-Kraft/Zeit-Profil durchläuft, um die Kraft zu verändern, mit der das Bauteil (B) durch den Klebstoff (K) auf das Substrat (S) gedrängt wird.

8. Verfahren zum Betreiben einer Thermokompressionsvorrichtung (100) nach Anspruch 7, wobei
in einer 4. Phase (P4), nach dem Ablauf der vorbestimmten Press-Zeit, das Unterwerkzeug (10) und das Oberwerkzeug (20) sich relativ voneinander weg aus der Geschlossen-Position (GP) in die Offen-Position (OP) bewegen.

9. Verfahren zum Betreiben einer Thermokompressionsvorrichtung (100) nach einem der Ansprüche 5, soweit rückbezogen auf Anspruch 4, oder 6 bis 8, wobei
in den 2. und 3. Phasen (P2, P3) eine Steuerung (50) einen Vergleich des Zeitpunkts (X) des Berührens des Bauteils (B) und/oder des Ermittelns dessen Position oder Höhe auf dem Substrat (S) mit einem vorbestimmten Weg- oder Positionswert (TF) nach Beginn des Bewegens aus der Offen-Position (OP) in die Geschlossen-Position (GP) ausführt, und
- bei Abweichen, insbesondere Unterschreiten des vorbestimmten Weg- oder Positionswerts (TF) um mehr als einen vorbestimmten ersten Abweichungswert (AF1) eine Fehlersituation detektiert, und eine Fehlermeldung oder eine Unterbrechungsanforderung signalisiert; und/oder
- bei Abweichen, insbesondere Unterschreiten des vorbestimmten Weg- oder Positionswerts (TF) um weniger als einen zweiten vorbestimmten Abweichungswert (AF2) eine Fehlersituation detektiert, und eine Fehlermeldung oder eine Unterbrechungsanforderung signalisiert; und/oder
- bei Abweichen insbesondere Überschreiten des vorbestimmten Weg- oder Positionswerts (TF) um einen vorbestimmten dritten Abweichungswert (AF3) eine Fehlersituation detektiert, und eine Fehlermeldung oder eine Unterbrechungsanforderung signalisiert.

10. Verfahren zum Betreiben einer Thermokompressionsvorrichtung (100) nach einem der Ansprüche 4 bis 9, wobei
ein Kraftsensor (40) eine Anpresskraft zwischen dem Unterwerkzeug (10) und dem Oberwerkzeug (20) auf das zwischen diesen befindliche Substrat (S), das auf dem Substrat (S) angeordnete Bauteil (B), und den zwischen das Bauteil (B) und das Substrat (S) eingebrachten Klebstoff (K) zumindest in ausgewählten aufeinanderfolgender Geschlossen-Positionen des Unterwerkzeugs (10) und des Oberwerkzeugs (20) erfasst und an eine Steuerung (50) signalisiert; und/oder wobei
eine Erfassung einer Auflagekraft (TARA) nach dem Eintragen des Substrats (S) oder eines Abschnitts des Substrats (S) mit dem darauf angeordneten Bauteil (B) und dem zwischen diesen eingebrachten Klebstoff (K) zwischen das Unterwerkzeug (10) und das Oberwerkzeug (20) erfolgt, bevor die Bewegung des Unterwerkzeugs (10) und des Oberwerkzeugs (20) relativ zueinander aus der Offen-Position (OP) in die Geschlossen-Position (GP) abgeschlossen ist.

11. Verfahren zum Betreiben einer Thermokompressionsvorrichtung (100) nach einem der Ansprüche 4 bis 10, wobei
eine Steuerung (50) vorgesehen ist, der
ein Indexing-Register (IR) für das Substrat (S) zugeordnet ist, in dem Bestückungspositionen des Substrats (S) einzutragen sind, auf denen ein Bauteil (B) angeordnet ist, oder auf denen kein Bauteil (B) angeordnet ist; und wobei
die Steuerung (50) aus dem Indexing-Register (IR) die Bestückungspositionen des Substrats (S) ausliest, auf denen ein Bauteil (B) angeordnet ist, und an diesen Bestückungspositionen das Verbinden des Bauteils (B) mit dem Substrat (S) durch Aushärten des Klebstoffs (K) ausgeführt wird; und/oder
die Steuerung (50) aus dem Indexing-Register (IR) die Bestückungspositionen des Substrats (S) ausliest, auf denen kein Bauteil (B) angeordnet ist, und an diesen Bestückungspositionen das Verbinden des Bauteils (B) mit dem Substrat (S) durch Aushärten des Klebstoffs (K) nicht ausgeführt wird.

12. Verfahren zum Betreiben einer Thermokompressionsvorrichtung (100) nach Anspruch 11, wobei
die Steuerung (50) in das Indexing-Register (IR) für jede der Bestückungspositionen einträgt,
• ob die Bestückungsposition ohne Bauteil ist,
• ob an der Bestückungsposition Klebstoff vorhanden ist,
• ob an der Bestückungsposition Bauteil und Klebstoff vorhanden sind, und/oder
• sofern an der Bestückungsposition zumindest das Bauteil vorhanden ist, Position des Bauteils als X,Y-Koordinaten und dessen Rotationswinkel.

13. Verfahren zum Betreiben einer Thermokompressionsvorrichtung (100) nach einem der Ansprüche 9 bis 12, wobei
die Steuerung (50) bestimmt und veranlasst, dass sofern die Bestückungsposition ohne Bauteil ist, die Schritte zum Verbinden des Bauteils (B) mit dem Substrat (S) nicht ausgeführt werden; und/oder
die Steuerung (50) bestimmt und veranlasst, dass sofern an der Bestückungsposition Klebstoff (K) vorhanden ist, das Unterwerkzeug (10) und das Oberwerkzeug (20) relativ zueinander in eine Zwischen-Position (ZP) bewegt werden, um den Klebstoff (K) berührungslos auszuhärten; und/oder
die Steuerung (50) bestimmt und veranlasst, dass sofern an der Bestückungsposition Bauteil und Klebstoff vorhanden sind, das Verbinden des Bauteils (B) mit dem Substrat (S) durch Aushärten des Klebstoffs (K) ausgeführt wird.

14. Verfahren zum Betreiben einer Thermokompressionsvorrichtung (100) nach einem der Ansprüche 11 bis 13, wobei
der Steuerung (50) in das Indexing-Register (IR) für jede der Bestückungspositionen einzutragende Daten, Bildeinzüge oder aus Bildeinzügen ermittelte Metadaten zur Klebstoffaushärtung, der Bauteilposition Position X, Y und der Bauteilrotation aus einem der Vorrichtung (100) vorgelagerten Maschinenmodul (MM) und/oder einem der Vorrichtung (100) vorgelagerten bildeinziehenden Inspektionssystem (IS) signalisiert werden, und in der Steuerung (50) weiterverarbeitet werden.

15. Verfahren zum Betreiben einer Thermokompressionsvorrichtung (100) nach einem der Ansprüche 11 bis 14, wobei
der Steuerung (50) aus einem der Vorrichtung (100) nachgelagerten bildeinziehenden Inspektionssystem (IS) Bildeinzüge oder aus Bildeinzügen ermittelte Metadaten zur Klebstoffaushärtung, der Bauteilposition Position X, Y und der Bauteilrotation signalisiert werden, damit diese weiterverarbeitet und/oder an eine nach- oder übergeordnete Prozess-Station weitergereicht werden.

## Claims

1. A thermocompression apparatus (100) for connecting electrical components (B) to a substrate (S), having
a lower tool (10) with a support surface (14) for supporting the substrate (S) with at least one electrical component (B) arranged thereon, and
an upper tool (20) with a pressing element (22) facing the support surface (14) of the lower tool (10), wherein
the lower tool (10) and the upper tool (20) are movable relative to each other in an open/close movement, wherein
the lower tool (10) and/or the upper tool (20) are set up to
perform the open/close movement by means of a first actuator (24) and a second actuator (26), wherein
the first actuator (24) is set up to perform a first movement (M1) within a first stroke range, wherein the first movement (M1) has an acceleration section (A1), a high-speed section (A2), and a deceleration section (A3); and
the second actuator (26) is set up to perform a second movement (M2) within a second stroke range, wherein the second movement (M2) has an acceleration section (V1), a high-speed section (V2), and a deceleration section (V3); and wherein
a movement speed during the high-speed section (A2) of the first movement (M1) is lower than a movement speed during the high-speed section (V2) of the second movement (M2); and
the first stroke range is greater than the second stroke range; and wherein
the lower tool (10) or the upper tool (20) carries a thermode assembly (30) assigned to the support surface (14) and/or the pressing element (22), which is set up to feed heating energy to the component (B) and/or the substrate (S) in order to thermally cure an adhesive (K) introduced between the component (B) and the substrate (S).

2. Thermocompression apparatus (100) according to claim 1, wherein
the first actuator (24) is set up to move the lower tool (10) or the upper tool (20) in the first movement between a first position and a second position; and
the second actuator (26) is set up to move the lower tool (10) or the upper tool (20) in the second movement between the second position and a third position; wherein, preferably,
the first position is a park position (PP), the second position is an open position (OP), and the third position is a closed position (GP); and/or wherein
the first actuator (24) and the second actuator (26) are set up and controlled to execute the first movement and the second movement either consecutively or overlapping in time.

3. Thermocompression apparatus (100) according to claim 1 or 2, wherein
the first actuator (24) and the second actuator (26) are configured to act in the same direction or in opposite directions in order to cause the open/close movement of the lower tool (10) and the upper tool (20); and/or
wherein the first actuator (24) and the second actuator (26) either
both are assigned to the lower tool (10) or the upper tool (20); or
one of the two actuators (24, 26) is assigned to the lower tool (10) and the other of the two actuators (24, 26) is assigned to the upper tool (20); and/or
wherein the thermode assembly (30) is set up and controlled to feed heating energy within a temperature range of about 300°C to about 500°C during a heating interval of about 0.07 to about 1.5 seconds, or about 0.1 to less than about 1 second into the component (B) and/or the substrate (S), in order to thermally cure the adhesive (K) applied between the component (B) and the substrate (S); and/or wherein
the thermode assembly (30) has a contact surface (38) for the heating energy of approximately circular shape and a diameter of less than approximately 5 mm; and/or wherein
the thermode assembly (30) comprises a thermal insulating body which almost completely surrounds a heating element (34) to be energized, wherein at least the contact surface (38) is exposed; and/or
wherein a force sensor (40) is assigned to the lower tool (10) and/or the upper tool (20), which is set up to detect a contact force between the lower tool (10) and the upper tool (20) on the substrate (S) located between them, the component (B) arranged on the substrate (S), and the adhesive (K) applied between the component (B) and the substrate (S), at least in selected successive closed positions of the lower tool (10) and the upper tool (20), and to signal it to a controller (50); and/or wherein the first actuator (24) is designed as a pneumatic or hydraulic cylinder, and the second actuator (26) is designed as a plunger coil actuator; and/or
wherein the first actuator (24) and/or the second actuator (26) are controlled by the controller (50) in control loop operation during the first movement (M1) or the second movement (M2), respectively, wherein a force and/or displacement measurement is used to determine a desired quantity, in particular a displacement position of the first actuator (24) and/or the second actuator (26), or a force on the substrate (S) located between them, the component (B) arranged on the substrate (S), and the adhesive (K) applied between the component (B) and the substrate (S).

4. A method for operating a thermocompression apparatus (100) for connecting electrical components (B) to a substrate (S) according to one or more of claims 1 to 3, comprising the steps of:
placing the substrate (S), with at least one electrical component (B) arranged thereon, on a support surface (14) of the lower tool (10) under a pressing element (22) of an upper tool (20);
moving the lower tool (10) and the upper tool (20) relative to each other in an open/close movement by means of a first actuator (24) and a second actuator (26); wherein
the first actuator (24) performs a first movement (M1) within a first stroke range, wherein the first movement (M1) has an acceleration section (A1), a high-speed section (A2), and a deceleration section (A3); and
the second actuator (26) performs a second movement within a second stroke range, wherein the second movement (M2) has an acceleration section (V1), a high-speed section (V2), and a deceleration section (V3); and wherein
a movement speed during the high-speed section (A2) of the first movement (M1) is lower than a movement speed during the high-speed section (V2) of the second movement (M2); and
the first stroke range is greater than the second stroke range; and wherein
the lower tool (10) or the upper tool (20) carries a thermode assembly (30), assigned to the support surface (14) or the pressing element (22), which is set up to feed heating energy to the component (B) and/or the substrate (S) during at least a part of the open/close movement in order to thermally cure an adhesive (K) applied between the component (B) and the substrate (S).

5. The method for operating a thermocompression apparatus (100) according to claim 4, wherein
the first actuator (24) moves the lower tool (10) or the upper tool (20) relative to each other in the first movement between a first position and a second position; and
the second actuator (26) moves the lower tool (10) or the upper tool (20) relative to each other in the second movement between the second position and a third position; wherein, preferably,
the first position is a park position (PP), the second position is an open position (OP), and the third position is a closed position (GP), and/or wherein
the first actuator (24) and the second actuator (26) execute the first movement (M1) and the second movement (M2) either consecutively or overlapping in time; and/or
wherein the substrate (S) with the component (B) and the adhesive (K), are conveyed continuously and/or intermittently between the support surface (14) and the pressing element (22) of the lower tool (10) or the upper tool (20) in the open position of the lower tool (10) and the upper tool (20); and/or
wherein, in a first phase (P1), after the first actuator (24) has executed the first movement (M1) to the extent that the lower tool (10) and the upper tool (20) have moved from the park position (PP) into the open position (OP), the second actuator (26) begins to execute the second movement (M2) so that the lower tool (10) and the upper tool (20) move relative to each other from the open position (OP) to the closed position (GP); and/or
wherein, in the acceleration section (V1), the second actuator (26) accelerates to execute the second movement (M2) until a predetermined first target speed, e. g., 100 mm/s to 300 mm/s, e. g., 200 mm/s, is reached at which the lower tool (10) and the upper tool (20) move relative to each other from the open position (OP) to the closed position (GP); and/or
wherein, in the deceleration section (V3), the second actuator (26) executes the second movement until a predetermined second, lower than the first, target speed, e. g., 2 mm/s to 20 mm/s, e. g., 5 mm/s, is reached at which the lower tool (10) and the upper tool (20) move relative to each other from the open position (OP) to the closed position (GP); and/or
wherein, in a second phase (P2) which follows the deceleration section (V3) of the second movement (M2), while the lower tool (10) and the upper tool (20) move relative to each other from the open position (OP) to the closed position (GP),
- in order to, by contacting the component (B), determine the component (B) and/or its position on the substrate (S), a control signal of the second actuator (26), e. g., a control voltage of the plunger coil actuator, is limited to a predetermined maximum value in order, upon impact of the pressing element (22) of the upper tool (20) on the component (B), not to damage same; and/or
- to detect the component (B) and/or its position on the substrate (S), the instantaneous velocity 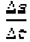 of the lower tool (10) relative to the upper tool (20) is continuously or intermittently monitored for a drop below a threshold value, e. g. 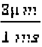 , wherein the threshold value lies between 1 and 4 orders of magnitude below the second target speed, and wherein this drop below the threshold value is interpreted as touching the component (B) on the substrate (S) by means of the upper tool (10).

6. The method for operating a thermocompression apparatus (100) according to claim 5, wherein
in a third phase (P3), while the lower tool (10) and the upper tool (20) have reached the closed position (GP) relative to each other and the component (B) has been touched, the actuator signal of the second actuator (26), e. g., an actuator voltage of the plunger coil actuator, is limited during a predetermined pressing time to a predetermined pressing value that is representative of the force with which the component (B) is pressed onto the substrate (S) by the adhesive (K).

7. The method for operating a thermocompression apparatus (100) according to claim 6, wherein
in the third phase (P3), while the lower tool (10) and the upper tool (20) have reached the closed position (GP) relative to each other and the component (B) has been touched, the actuator signal of the second actuator (26), e. g., an actuator voltage of the plunger coil actuator, passes through a predetermined press value force/time profile during the predetermined press time to change the force with which the component (B) is pressed onto the substrate (S) by the adhesive (K).

8. The method for operating a thermocompression apparatus (100) according to claim 7, wherein
in a fourth phase (P4), after the predetermined pressing time has elapsed, the lower tool (10) and the upper tool (20) move relative to each other away from the closed position (GP) to the open position (OP).

9. The method for operating a thermocompression apparatus (100) according to any one of claims 5, as referred back to claim 4, or 6 to 8, wherein
in the second and third phases (P2, P3), a controller (50) carries out a comparison of the time (X) of touching the component (B) and/or determining its position or height on the substrate (S) with a predetermined displacement or position value (TF) after start of movement from the open position (OP) into the closed position (GP), and
- in the event of a deviation, in particular if the value falls below the predetermined displacement or position value (TF) by more than a predetermined first deviation value (AF1), detects an error condition and signals an error message or an interruption request; and/or
- in the event of a deviation, in particular if the value falls below the predetermined displacement or position value (TF) by less than a second predetermined deviation value (AF2) and signals an error message or an interrupt request; and/or
- in the event of a deviation, in particular exceeding the predetermined displacement or position value (TF) by a predetermined third deviation value (AF3), detects an error condition and signals an error message or an interrupt request.

10. The method for operating a thermocompression apparatus (100) according to any one of claims 4 to 9, wherein
a force sensor (40) detects a contact force between the lower tool (10) and the upper tool (20) on the substrate (S) located between them, the component (B) arranged on the substrate (S), and the adhesive (K) applied between the component (B) and the substrate (S), at least in selected successive closed positions of the lower tool (10) and the upper tool (20), and signals this to a controller (50); and/or wherein
a detection of a contact force (TARA) is made after insertion of the substrate (S) or a section of the substrate (S) with the component (B) arranged thereon and the adhesive (K) applied between them, between the lower tool (10) and the upper tool (20) before the movement of the lower tool (10) and the upper tool (20) relative to each other from the open position (OP) to the closed position (GP) is completed.

11. The method for operating a thermocompression apparatus (100) according to one of claims 4 to 10, wherein
a controller (50) is provided, to which
an indexing register (IR) for the substrate (S) is assigned, in which placement positions of the substrate (S) are to be entered, at which a component (B) is arranged or at which no component (B) is arranged; and wherein
the controller (50) reads from the indexing register (IR) the placement positions on the substrate (S) at which a component (B) is arranged, and at these placement positions, the connecting of the component (B) to the substrate (S) by curing the adhesive (K) is performed; and/or
the controller (50) reads from the indexing register (IR) the placement positions of the substrate (S) where no component (B) is placed, and at these placement positions, the connecting of the component (B) to the substrate (S) by curing the adhesive (K) is not performed.

12. The method for operating a thermocompression apparatus (100) according to claim 11, wherein
the controller (50) enters into the indexing register (IR) for each of the placement positions
• whether the placement position is without a component,
• whether adhesive is present at the placement position,
• whether a component and adhesive are present at the placement position, and/or
• provided that at least the component is present at the placement position, the position of the component as X, Y coordinates and its angle of rotation.

13. The method for operating a thermocompression apparatus (100) according to one of claims 9 to 12, wherein
the controller (50) determines and causes that, if the placement position is without a component, the steps for connecting the component (B) to the substrate (S) are not performed; and/or
the controller (50) determines and causes that, if adhesive (K) is present at the placement position, the lower tool (10) and the upper tool (20) are moved relative to each other into an intermediate position (ZP) in order to cure the adhesive (K) without contact; and/or
the controller (50) determines and causes that, if component and adhesive are present at the placement position, connecting of the component (B) to the substrate (S) by curing the adhesive (K) is performed.

14. The method for operating a thermocompression apparatus (100) according to one of claims 11 to 13, wherein
the data, image captures, or metadata derived from image captures for adhesive curing to be entered into the indexing register (IR) for each of the placement positions, the component position X, Y, and the component rotation are signaled to a machine module (MM) upstream of the device (100) and/or an image-acquiring inspection system (IS) upstream of the device (100) are signaled to the controller (50), and are further processed in the controller (50).

15. The method for operating a thermocompression apparatus (100) according to one of claims 11 to 14, wherein
image captures or metadata regarding adhesive curing determined from image captures, the component position X, Y and the component rotation are signaled to the controller (50) so that these can be further processed and/or forwarded to a downstream or upstream process station.

## Revendications

1. Un dispositif de thermocompression (100) destiné à assembler des composants électriques (B) à un substrat (S), comprenant
d'un outil inférieur (10) comportant une surface d'appui (14) destinée à recevoir le substrat (S) sur lequel est disposé au moins un composant électrique (B), et
d'un outil supérieur (20) comportant un élément de pression (22) tourné vers la surface d'appui (14) de l'outil inférieur (10),
l'outil inférieur (10) et l'outil supérieur (20) sont mobiles l'un par rapport à l'autre selon un mouvement d'ouverture/de fermeture,
l'outil inférieur (10) et/ou l'outil supérieur (20) sont agencés pour
effectuer le mouvement d'ouverture/de fermeture à l'aide d'un premier entraînement (24) et d'un deuxième entraînement (26),
le premier entraînement (24) est agencé pour effectuer un premier mouvement (M1) dans une première plage de course, le premier mouvement (M1) comportant une phase d'accélération (A1), une phase de marche rapide (A2) et une phase de décélération (A3); et
le deuxième entraînement (26) est conçu pour effectuer un deuxième mouvement (M2) dans une deuxième plage de course, le deuxième mouvement (M2) comportant une phase d'accélération (V1), une phase de marche rapide (V2) et une phase de décélération (V3); et
la vitesse de déplacement pendant la phase de déplacement rapide (A2) du premier mouvement (M1) est inférieure à la vitesse de déplacement pendant la phase de déplacement rapide (V2) du deuxième mouvement (M2); et
la première plage de course est supérieure à la deuxième plage de course; et dans lequel
l'outil inférieur (10) ou l'outil supérieur (20) porte un ensemble de thermodes (30) associé à la surface d'appui (14) et/ou à l'élément de pression (22), lequel est agencé pour injecter de l'énergie thermique dans la pièce (B) et/ou le substrat (S) afin de durcir thermiquement une colle (K) appliquée entre le composant (B) et le substrat (S).

2. Le dispositif de thermocompression (100) selon la revendication 1, dans lequel
le premier entraînement (24) est agencé pour déplacer l'outil inférieur (10) ou l'outil supérieur (20) selon le premier mouvement entre une première position et une deuxième position; et
le deuxième entraînement (26) est agencé pour déplacer l'outil inférieur (10) ou l'outil supérieur (20) selon le deuxième mouvement entre la deuxième position et une troisième position; dans lequel, de préférence
la première position est une position de stationnement (PP), la deuxième position une position ouverte (OP) et la troisième position une position fermée (GP) ; et/ou dans lequel
le premier entraînement (24) et le deuxième entraînement (26) sont conçus et peuvent être commandés pour exécuter le premier mouvement et le deuxième mouvement soit successivement, soit en se chevauchant dans le temps.

3. Le dispositif de thermocompression (100) selon la revendication 1 ou 2, dans lequel
le premier entraînement (24) et le deuxième entraînement (26) sont agencés pour agir dans le même sens ou dans des sens opposés afin de provoquer le mouvement d'ouverture/de fermeture de l'outil inférieur (10) et de l'outil supérieur (20); et/ou
dans lequel le premier entraînement (24) et le deuxième entraînement (26) sont soit
sont tous deux associés à l'outil inférieur (10) ou à l'outil supérieur (20); ou
l'un des deux entraînements (24, 26) est associé à l'outil inférieur (10) et l'autre des deux entraînements (24, 26) est associé à l'outil supérieur (20); et/ou
l'ensemble de thermodes (30) étant conçu et pouvant être commandé pour fournir à la pièce (B) et/ou au substrat (S) de l'énergie thermique dans une plage de température comprise entre environ 300 °C et environ 500 °C pendant un intervalle de chauffage d'environ 0,07 à environ 1,5 seconde, ou d'environ 0,1 à moins d'environ 1 seconde, afin de durcir thermiquement la colle (K) appliquée entre le composant (B) et le substrat (S); et/ou dans lequel
l'ensemble de thermodes (30) présente une surface de contact (38) pour l'énergie thermique, de forme approximativement circulaire et d'un diamètre inférieur à environ 5 mm; et/ou dans lequel
l'ensemble de thermodes (30) comprend un corps isolant thermique qui entoure presque entièrement un élément chauffant (34) devant être alimenté en courant, au moins la surface de contact (38) étant exposée; et/ou
dans lequel un capteur de force (40) est associé à l'outil inférieur (10) et/ou à l'outil supérieur (20), lequel est conçu pour mesurer une force de pression entre l'outil inférieur (10) et l'outil supérieur (20) exercée sur le substrat (S) situé entre ceux-ci, sur le composant (B) disposé sur le substrat (S), et la colle (K) introduite entre le composant (B) et le substrat (S) par l' , au moins dans certaines positions fermées successives sélectionnées de l'outil inférieur (10) et de l'outil supérieur (20), et de la transmettre à une unité de commande (50) ; et/ou dans lequel le premier entraînement (24) est conçu comme un vérin pneumatique ou hydraulique, et le deuxième entraînement (26) est conçu comme un actionneur à bobine plongeante; et/ou
le premier entraînement (24) et/ou le deuxième entraînement (26) étant commandés par la commande (50) en mode de boucle de régulation respectivement pendant le premier mouvement (M1) et le deuxième mouvement (M2), une mesure de force et/ou de course étant utilisée pour déterminer une grandeur de consigne, notamment d'une position de déplacement du premier entraînement (24) et/ou du deuxième entraînement (26), ou d'une force exercée sur le substrat (S) situé entre ceux-ci, sur le composant (B) disposé sur le substrat (S) et sur l'adhésif (K) appliqué entre le composant (B) et le substrat (S).

4. Une méthode de mise en œuvre d'un dispositif de thermocompression (100) destiné à assembler des composants électriques (B) à un substrat (S) selon l'une ou plusieurs des revendications 1 à 3, comprenant les étapes suivantes:
placer le substrat (S), sur lequel est disposé au moins un composant électrique (B), sur une surface d'appui (14) de l'outil inférieur (10) sous un élément de pression (22) d'un outil supérieur (20);
déplacer l'outil inférieur (10) et de l'outil supérieur (20) l'un par rapport à l'autre selon un mouvement d'ouverture/de fermeture par un premier entraînement (24) et un deuxième entraînement (26); dans laquelle
le premier entraînement (24) effectue un premier mouvement (M1) dans une première plage de course, le premier mouvement (M1) comportant une phase d'accélération (A1), une phase de déplacement rapide (A2) et une phase de décélération (A3); et
le deuxième entraînement (26) effectue un deuxième mouvement dans une deuxième plage de course, ce deuxième mouvement (M2) comportant une phase d'accélération (V1), une phase de marche rapide (V2) et une phase de décélération (V3); et dans laquelle
la vitesse de déplacement pendant la phase de vitesse élevée (A2) du premier mouvement (M1) est inférieure à la vitesse de déplacement pendant la phase de vitesse élevée (V2) du deuxième mouvement (M2); et
la première plage de course est supérieure à la deuxième plage de course ; et dans laquelle
l'outil inférieur (10) ou l'outil supérieur (20) porte un ensemble de thermodes (30) associé respectivement à la surface d'appui (14) ou à l'élément de pression (22), lequel est agencé pour, pendant au moins une partie du mouvement d'ouverture/de fermeture, fournir de l'énergie thermique au composant (B) et/ou au substrat (S) afin de durcir thermiquement une colle (K) appliquée entre le composant (B) et le substrat (S).

5. La méthode de mise en œuvre d'un dispositif de thermocompression (100) selon la revendication 4, dans laquelle
le premier entraînement (24) déplace l'outil inférieur (10) ou l'outil supérieur (20) selon le premier mouvement entre une première position et une deuxième position l'un par rapport à l'autre; et
le deuxième entraînement (26) déplace l'outil inférieur (10) ou l'outil supérieur (20) selon le deuxième mouvement entre la deuxième position et une troisième position l'un par rapport à l'autre; dans laquelle, de préférence,
la première position est une position de stationnement (PP), la deuxième position est une position ouverte (OP) et la troisième position est une position fermée (GP), et/ou dans laquelle
le premier entraînement (24) et le deuxième entraînement (26) effectuent le premier mouvement (M1) et le deuxième mouvement (M2) soit successivement, soit en se chevauchant dans le temps; et/ou
le substrat (S), avec le composant (B) et l'adhésif (K), étant acheminé en continu et/ou par intermittence entre la surface d'appui (14) et l'élément de pression (22) de l'outil inférieur (10) ou de l'outil supérieur (20) dans la position ouverte de l'outil inférieur (10) et de l'outil supérieur (20); et/ou
dans laquelle, au cours d'une première phase (P1), une fois que le premier entraînement (24) a exécuté le premier mouvement (M1) au point que l'outil inférieur (10) et l'outil supérieur (20) se sont déplacés de la position de repos (PP) vers la position ouverte (OP), le deuxième entraînement (26) commence à exécuter le deuxième mouvement (M2) afin que l'outil inférieur (10) et l'outil supérieur (20) se déplacent l'un par rapport à l'autre de la position ouverte (OP) vers la position fermée (GP); et/ou
dans la phase d'accélération (V1), le deuxième entraînement (26) accélère pour effectuer le deuxième mouvement (M2) jusqu'à ce qu'une première vitesse de consigne prédéterminée, par exemple de 100 mm/s à 300 mm/s, par exemple 200 mm/s, à laquelle l'outil inférieur (10) et l'outil supérieur (20) se déplacent l'un par rapport à l'autre de la position ouverte (OP) à la position fermée (GP); et/ou
dans la section de décélération (V3), le deuxième entraînement (26) effectue le deuxième mouvement jusqu'à ce qu'une deuxième vitesse de consigne prédéterminée, inférieure à la première, par exemple comprise entre 2 mm/s et 20 mm/s, par exemple 5 mm/s, à laquelle l'outil inférieur (10) et l'outil supérieur (20) se déplacent l'un par rapport à l'autre de la position ouverte (OP) à la position fermée (GP); et/ou
dans une deuxième phase (P2), qui fait suite à la partie de décélération (V3) du deuxième mouvement (M2), tandis que l'outil inférieur (10) et l'outil supérieur (20) se déplacent l'un par rapport à l'autre de la position ouverte (OP) vers la position fermée (GP),
- afin de détecter, par contact avec la pièce (B), la pièce (B) et/ou sa position sur le substrat (S), un signal de commande du deuxième entraînement (26), par exemple une tension de commande de l'actionneur à bobine plongeante, est limitée à une valeur maximale prédéterminée afin de ne pas endommager le composant (B) en cas de contact entre l'élément de pression (22) de l'outil supérieur (20) et le composant (B); et/ou
- afin de détecter la pièce (B) et/ou sa position sur le substrat (S), une vitesse instantanée $\frac{Δ s}{Δ t}$ de l'outil inférieur (10) par rapport à l'outil supérieur (20) est surveillée en continu ou par intermittence pour détecter tout passage en dessous d'un seuil, par exemple $\frac{3 μ m}{1 ms}$, la valeur seuil se situant entre 1 et 4 ordres de grandeur en dessous de la deuxième vitesse de consigne, et ce passage en dessous de la valeur seuil étant interprété comme un contact de l'outil supérieur (10) avec le composant (B) sur le substrat (S).

6. La méthode de fonctionnement d'un dispositif de thermocompression (100) selon la revendication 5, dans laquelle
dans une troisième phase (P3), alors que l'outil inférieur (10) et l'outil supérieur (20) ont atteint la position fermée (GP) l'un par rapport à l'autre et que le contact avec le composant (B) a eu lieu, le signal de commande du deuxième entraînement (26), par exemple une tension de commande de l'actionneur à bobine plongeante, est limité pendant un temps de pressage prédéterminé à une valeur de pressage prédéterminée, représentative de la force avec laquelle la pièce (B) est pressée contre le substrat (S) par la colle (K).

7. La méthode de mise en œuvre d'un dispositif de thermocompression (100) selon la revendication 6, dans laquelle
au cours de la 3e phase (P3), alors que l'outil inférieur (10) et l'outil supérieur (20) ont atteint la position fermée (GP) l'un par rapport à l'autre et que le contact avec le composant (B) a été établi, le signal de commande du deuxième entraînement (26), par exemple une tension de commande de l'actionneur à bobine plongeante, suit un profil de force/temps prédéterminé pendant la durée de pressage prédéterminée, afin de modifier la force avec laquelle la pièce (B) est pressée contre le substrat (S) par la colle (K).

8. La méthode de mise en œuvre d'un dispositif de thermocompression (100) selon la revendication 7, dans laquelle
au cours d'une 4e phase (P4), à l'issue de la durée de pressage prédéterminée, l'outil inférieur (10) et l'outil supérieur (20) s'écartent l'un de l'autre, passant de la position fermée (GP) à la position ouverte (OP).

9. La méthode de mise en œuvre d'un dispositif de thermocompression (100) selon l'une des revendications 5, dans la mesure où elle se réfère à la revendication 4, ou 6 à 8, dans laquelle
au cours des 2e et 3e phases (P2, P3), une unité de commande (50) effectue une comparaison entre l'instant (X) du contact avec le composant (B) et/ou de la détermination de sa position ou de sa hauteur sur le substrat (S) et une valeur de course ou de position prédéterminée (TF) après le début du déplacement de la position ouverte (OP) vers la position fermée (GP), et
- en cas d'écart, notamment si la valeur de course ou de position prédéterminée (TF) n'est pas atteinte d'une valeur supérieure à une première valeur d'écart prédéterminée (AF1), détecte une situation d'erreur et signale un message d'erreur ou une demande d'interruption; et/ou
- en cas d'écart, notamment si la valeur de course ou de position prédéterminée (TF) n'est pas atteinte d'une valeur inférieure à une deuxième valeur d'écart prédéterminée (AF2), détecte une situation d'erreur et signale un message d'erreur ou une demande d'interruption; et/ou
- en cas d'écart, notamment de dépassement de la valeur prédéterminée de course ou de position (TF) d'une troisième valeur d'écart prédéterminée (AF3), une situation d'erreur est détectée et un message d'erreur ou une demande d'interruption est signalé.

10. La méthode de mise en œuvre d'un dispositif de thermocompression (100) selon l'une des revendications 4 à 9, dans laquelle
un capteur de force (40) mesure une force de pression entre l'outil inférieur (10) et l'outil supérieur (20) sur le substrat (S) situé entre ceux-ci, le composant (B) disposé sur le substrat (S), et l'adhésif (K) introduit entre le composant (B) et le substrat (S), au moins dans certaines positions fermées successives sélectionnées de l'outil inférieur (10) et de l'outil supérieur (20), et la transmet à une unité de commande (50) ; et/ou dans laquelle
une détection d'une force d'appui (TARA) après l'insertion du substrat (S) ou d'une partie du substrat (S) sur laquelle est disposé le composant (B) et entre laquelle a été introduit l'adhésif (K) entre l'outil inférieur (10) et l'outil supérieur (20), avant que le déplacement de l'outil inférieur (10) et de l'outil supérieur (20) l'un par rapport à l'autre, de la position ouverte (OP) à la position fermée (GP), ne soit achevé.

11. La méthode de mise en œuvre d'un dispositif de thermocompression (100) selon l'une des revendications 4 à 10, dans laquelle
il est prévu une unité de commande (50) à laquelle
est associé un registre d'indexation (IR) pour le substrat (S), dans lequel doivent être enregistrées les positions de montage du substrat (S) sur lesquelles un composant (B) est disposé, ou sur lesquelles aucun composant (B) n'est disposé; et dans laquelle
la commande (50) lit dans le registre d'indexation (IR) les positions de montage du substrat (S) sur lesquelles un composant (B) est disposé, et c'est à ces positions de montage que la liaison du composant (B) au substrat (S) est réalisée par durcissement de la colle (K); et/ou
la commande (50) lit dans le registre d'indexation (IR) les positions de montage du substrat (S) sur lesquelles aucun composant (B) n'est disposé, et à ces positions de montage, la fixation du composant (B) au substrat (S) par durcissement de la colle (K) n'est pas effectuée.

12. La méthode de mise en œuvre d'un dispositif de thermocompression (100) selon la revendication 11, dans laquelle
le dispositif de commande (50) enregistre dans le registre d'indexation (IR), pour chacune des positions de montage,
• si la position de montage est dépourvue de composant,
• s'il y a de la colle à la position de montage,
• si un composant et de la colle sont présents à la position de placement, et/ou
• si au moins le composant est présent à la position de placement, la position du composant sous forme de coordonnées X, Y et son angle de rotation.

13. La méthode de mise en œuvre d'un dispositif de thermocompression (100) selon l'une des revendications 9 à 12, dans laquelle
la commande (50) détermine et fait en sorte que, si la position de placement ne comporte pas de composant, les étapes de liaison du composant (B) au substrat (S) ne soient pas exécutées; et/ou
la commande (50) détermine et fait en sorte que, si de la colle (K) est présente à la position de placement, l'outil inférieur (10) et l'outil supérieur (20) soient déplacés l'un par rapport à l'autre vers une position intermédiaire (ZP) afin de durcir la colle (K) sans contact; et/ou
la commande (50) détermine et fait en sorte que, dès lors qu'un composant et de la colle sont présents à la position de montage, l'assemblage du composant (B) avec le substrat (S) soit effectué par durcissement de la colle (K).

14. La méthode de mise en œuvre d'un dispositif de thermocompression (100) selon l'une des revendications 11 à 13, dans laquelle
les données, les images ou les métadonnées relatives au durcissement de la colle, déterminées à partir des images, que la commande (50) doit enregistrer dans le registre d'indexation (IR) pour chacune des positions de placement, la position du composant X, Y et de la rotation du composant, sont signalées par un module de machine (MM) en amont du dispositif (100) et/ou par un système d'inspection (IS) capturant des images en amont du dispositif (100), et sont traitées ultérieurement dans la commande (50).

15. La méthode de mise en œuvre d'un dispositif de thermocompression (100) selon l'une des revendications 11 à 14, dans laquelle
le système de commande (50) reçoit, provenant d'un système d'inspection à acquisition d'images (IS) situé en aval du dispositif (100), des images ou des métadonnées relatives au durcissement de la colle, à la position du composant (position X), Y et de la rotation du composant sont signalées à la commande (50), afin qu'elles soient traitées et/ou transmises à une station de processus en aval ou de niveau supérieur.
